(19) Europäisches Patentamt
European Patent Office
Office européen des brevets

(11) **EP 2 068 448 B1**

(12) **EUROPÄISCHE PATENTSCHRIFT**


(45) Veröffentlichungstag und Bekanntmachung des Hinweises auf die Patenterteilung:
**06.11.2013 Patentblatt 2013/45**

(51) Int Cl.:
***H04N 7/26*** *(2006.01)*

(21) Anmeldenummer: **08020113.0**

(22) Anmeldetag: **02.05.2003**


(54) **Verfahren und Anordnung zur arithmetischen Enkodierung und Dekodierung mit Verwendung mehrerer Tabellen**

Method and arrangement for arithmetic encoding and decoding with application of several tables

Procédé et agencement d'encodage et de décodage arithmétiques avec utilisation de plusieurs tableaux


(84) Benannte Vertragsstaaten:
**AT BE BG CH CY CZ DE DK EE ES FI FR GB GR HU IE IT LI LU MC NL PT RO SE SI SK TR**

(30) Priorität: **02.05.2002 DE 10220962**

(43) Veröffentlichungstag der Anmeldung:
**10.06.2009 Patentblatt 2009/24**

(62) Dokumentnummer(n) der früheren Anmeldung(en) nach Art. 76 EPÜ:
**03725141.0 / 1 550 219**



(73) Patentinhaber: **Fraunhofer-Gesellschaft zur Förderung der angewandten Forschung e.V.**
**80686 München (DE)**

(72) Erfinder:
- **Marpe, Detlev**
  **12161 Berlin (DE)**
- **Wiegand, Thomas**
  **10719 Berlin (DE)**

(74) Vertreter: **Schenk, Markus et al**
**Schoppe, Zimmermann, Stöckeler & Zinkler**
**Patentanwälte**
**Postfach 246**
**82043 Pullach bei München (DE)**



(56) Entgegenhaltungen:
**US-A- 5 592 162**

- **D.S. TAUBMAN, M.W. MARCELLIN: "JPEG2000: image compression fundamentals, standards and practice" 2002, KLUWER ACADEMIC PUBLISHERS , XP002566993 Kapitel 2.3.5 * Tabelle 2.1 ***
- **CHEVION D ET AL: "High efficiency, multiplication free approximation of arithmetic coding" 8. April 1991 (1991-04-08), DATA COMPRESSION CONFERENCE, 1991. DCC '91. SNOWBIRD, UT, USA 8-11 APRIL 1991, LOS ALAMITOS, CA, USA,IEEE COMPUT. SOC, US, PAGE(S) 43 - 52 , XP010034259 ISBN: 978-0-8186-9202-4 * Seite 47, Absatz 1 ***



Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).





Printed by Jouve, 75001 PARIS (FR)

## Beschreibung

Die Erfindung betrifft ein Verfahren und eine Anordnung zur arithmetischen Enkodierung und Dekodierung von binären Zuständen sowie ein entsprechendes Computerprogramm und ein entsprechendes computerlesbares Speichermedium, welche insbesondere bei der digitalen Datenkompression eingesetzt werden können.

Die vorliegende Erfindung beschreibt ein neues effizientes Verfahren zur binären arithmetischen Kodierung. Der Bedarf nach binärer arithmetischer Kodierung entsteht in den verschiedensten Anwendungsbereichen der digitalen Datenkompression; hier sind vor allem Anwendungen in den Bereichen der digitalen Bildkompression von beispielhaften Interesse. In zahlreichen Standards zur Bildkodierung, wie etwa JPEG, JPEG-2000, JPEG-LS und JBIG wurden Verfahren zur binären arithmetischen Kodierung definiert. Neuere Standardisierungsaktivitäten lassen auch den zukünftigen Einsatz derartiger Kodiertechniken im Bereich der Videokodierung (CABAC in H.264/AVC) erkennen [1].

Die Vorteile der arithmetischen Kodierung (AK) gegenüber der bisher in der Praxis häufig verwendeten Huffman-Kodierung [2] lassen sich im wesentlichen durch drei Merkmale charakterisieren:

1. Mit der Verwendung der arithmetischen Kodierung lässt sich durch einfache Adaptionsmechanismen eine dynamische Anpassung an die vorhandene Quellenstatistik erzielen (Adaptivität).
2. Die arithmetische Kodierung erlaubt die Zuweisung von einer nicht ganzzahligen Anzahl von Bits pro zu kodierende Symbol und ist damit geeignet, Kodierresultate zu erzielen, die eine Approximation der Entropie als der theoretisch gegebenen unteren Schranke darstellen (Entropie-Approximation) [3].
3. Unter Zuhilfenahme geeigneter Kontextmodelle lassen sich mit der arithmetischen Kodierung statistische Bindungen zwischen Symbolen zur weiteren Datenreduktion ausnutzen (Intersymbol-Redundanz) [4].

Als Nachteil einer Anwendung der arithmetischen Kodierung wird der im Vergleich zur Huffman-Kodierung i. a. erhöhte Rechenaufwand angesehen.

Das Konzept der arithmetischen Kodierung geht zurück auf die grundlegenden Arbeiten zur Informationstheorie von Shannon [5]. Erste konzeptionelle Konstruktionsmethoden wurden in [6] erstmals von Elias veröffentlicht. Eine erste LIFO (last-in-first-out) Variante der arithmetischen Kodierung wurde von Rissanen [7] entworfen und später von verschiedenen Autoren zu FIFO-Ausbildungen (first-in-first-out) modifiziert [8] [9] [10].

Gemeinsam ist allen diesen Arbeiten das zugrundeliegende Prinzip der rekursiven Teilintervallzerlegung: Entsprechend den gegebenen Wahrscheinlichkeiten $P$("0") und $P$("1") zweier Ereignisse {"0", "1"} eines binären Alphabets wird ein anfänglich gegebenes Intervall, z.B. das Intervall [0, 1), je nach Auftreten von Einzelereignissen rekursiv in Teilintervall zerlegt. Dabei ist die Größe des resultierenden Teilintervalls als Produkt der Einzelwahrscheinlichkeiten der aufgetretenen Ereignisse proportional zur Wahrscheinlichkeit der Folge der Einzelereignisse. Da jedes Ereignis $S_i$ mit der Wahrscheinlichkeit $P(S_i)$ einen Beitrag von $H(S_i) = -log(P(S_i))$ des theoretischen Informationsgehalts $H(S_i)$ von $S_i$ zur Gesamtrate beiträgt, ergibt sich eine Beziehung zwischen der Anzahl $N_{Bit}$ der Bits zur Darstellung des Teilintervalls und der Entropie der Folge von Einzelereignissen, die durch die rechte Seite der folgenden Gleichung angegeben ist

$$N_{Bit} = -\log\prod_i P(S_i) = -\sum_i \log P(S_i) \quad .$$

Das Grundprinzip erfordert jedoch zunächst eine (theoretisch) unbegrenzte Genauigkeit in der Darstellung des resultierenden Teilintervalls und hat darüber hinaus den Nachteil, dass erst nach Kodierung des letzten Ereignisses die Bits zur Repräsentierung des resultierenden Teilintervalls ausgegeben werden können. Für praktische Anwendungszwecke war es daher entscheidend, Mechanismen für eine inkrementelle Ausgabe von Bits bei gleichzeitiger Darstellung mit Zahlen vorgegebener fester Genauigkeit zu entwickeln. Diese wurden erstmals in den Arbeiten [3] [7] [11] vorgestellt.

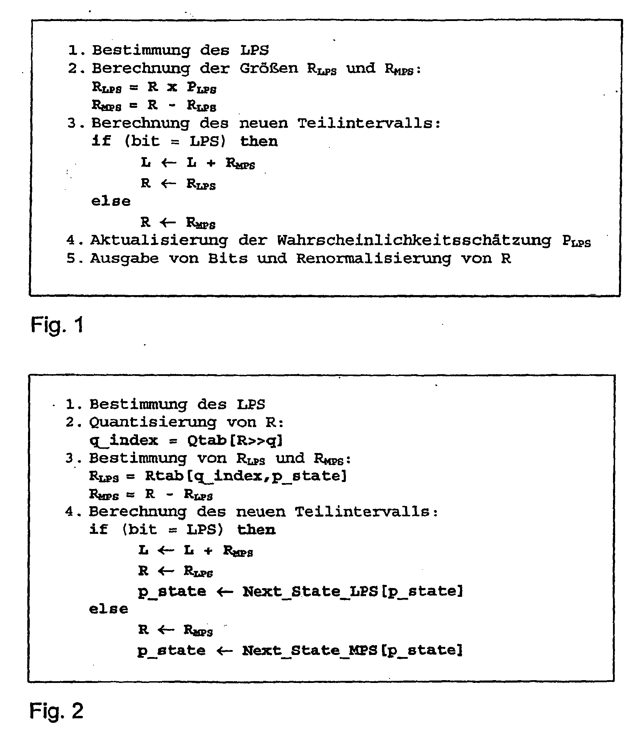

In Figur 1 sind die wesentlichen Operationen zur binären arithmetischen Kodierung skizziert. In der dargestellten Implementierung wird das aktuelle Teilintervall durch die beiden Werte L und R repräsentiert, wobei L den Aufsatzpunkt und R die Größe (Breite) des Teilintervalls bezeichnet und beide Größen mit jeweils b-bit Ganzzahlen dargestellt werden. Die Kodierung eines bit $\in \{0, 1\}$ erfolgt dabei im wesentlichen in fünf Teilschritten: Im ersten Schritt wird anhand der Wahrscheinlichkeitsschätzung der Wert des weniger wahrscheinlichen Symbols ermittelt. Für dieses Symbol, auch *LPS* (least probable symbol) in Unterscheidung zum *MPS* (most probable symbol) genannt, wird die Wahrscheinlichkeitsschätzung $P_{LPS}$ im zweiten Schritt zur Berechnung der Breite $R_{LPS}$ des entsprechenden Teilintervalls herangezogen. Je nach Wert des zu kodierenden Bits bit werden L und R im dritten Schritt aktualisiert. Im vierten Schritt wird die Wahrscheinlichkeitsschätzung je nach Wert des gerade kodierten Bits aktualisiert und schließlich wird das Codeintervall R im letzten Schritt einer sogenannten Renormalisierung unterzogen, d. h. R wird beispielsweise so reskaliert, dass die Bedingung $R \in [2^{b-2}, 2^{b-1})$ verfüllt ist. Dabei wird bei jeder Skalierungsoperation ein Bit ausgegeben. Für weitere Details sei auf [10] verwiesen.

Der wesentliche Nachteil einer Implementierung, wie oben skizziert, besteht nun darin, dass die Berechnung der Intervallbreite $R_{LPS}$ eine Multiplikation pro zu kodierendem Symbol erfordert. Üblicherweise sind Multiplikationsoperationen, insbesondere, wenn sie in Hardware realisiert werden, aufwändig und kostenintensiv. In mehreren Forschungsarbeiten wurden daher Verfahren untersucht, diese Multiplikationsoperation durch eine geeignete Approximation zu ersetzen [11] [12] [13] [14]. Hierbei können die zu diesem Thema veröffentlichten Verfahren grob in drei Kategorien eingeteilt werden.

Die erste Gruppe von Vorschlägen zu einer multiplikationsfreien, binären arithmetischen Kodierung basiert auf dem Ansatz, die geschätzten Wahrscheinlichkeiten $P_{LPS}$ so zu approximieren, dass die Multiplikation im 2. Schritt von Figur 1 durch eine (oder mehrere) Schiebe-und Additionsoperation(en) ersetzt werden kann [11] [14]. Hierzu werden im einfachsten Fall die Wahrscheinlichkeiten $P_{LPS}$ durch Werte in der Form $2^{-q}$ mit ganzahligem $q > 0$ angenähert.

In der zweiten Kategorie von approximativen Verfahren wird vorgeschlagen, den Wertebereich von $R$ durch diskrete Werte in der Form ($½ - r$) zu approximieren, wobei $r \in \{0\} \cup \{2^{-k} \mid k > 0, k \text{ ganzzahlig}\}$ gewählt wird [15] [16].

Die dritte Kategorie von Verfahren zeichnet sich schließlich dadurch aus, dass dort sämtliche arithmetische Operationen durch Tabellenzugriffe ersetzt werden. Zu dieser Gruppe von Verfahren gehören einerseits der im JPEG-Standard verwendete Q-Coder und verwandte Verfahren, wie der QM- und MQ-Coder [12], und andererseits der quasiarithmetische Koder [13]. Während das letztgenannte Verfahren eine drastische Einschränkung der zur Repräsentierung von $R$ verwendeten Anzahl $b$ von Bits vornimmt, um zu akzeptabel dimensionierten Tabellen zu gelangen, wird im Q-Coder die Renormalisierung von $R$ so gestaltet, dass $R$ zumindest näherungsweise durch 1 approximiert werden kann. Auf diese Art und Weise wird die Multiplikation zur Bestimmung von $R_{LPS}$ vermieden. Zusätzlich wird die Wahrscheinlichkeitsschätzung mittels einer Tabelle in Form einer Finite-State Machine betrieben. Für weitere Einzelheiten hierzu sei auf [12] verwiesen.

Die Patentschrift US5592162 beschreibt ein Verfahren für die Ausführung einer arithmetischen Kodierung, wobei die Zahl der möglichen Intervallbreiten begrenzt wird.

Durch die Verwendung eines Indexes, der sich auf diese Intervallbreiten bezieht, kann eine multiplikationsfreie arithmetische Kodierung mit einem reduzierten Speicheraufwand erreicht werden.

Bei dieser Erfindung handelt es sich um eine Anordnung und ein Verfahren zur arithmetischen Kodierung, eine Anordnung und ein Verfahren zur arithmetischen Dekodierung, ein Speichermedium und ein Computerprogramm entsprechend den Ansprüchen im Anhang.

Ein Verfahren zur arithmetischen Enkodierung und Dekodierung von binären Zuständen wird vorteilhafterweise so durchgeführt, daß in einem ersten Schritt ein vorgebbarer Wertebereich für die Spezifizierung der Intervallbreite $R$ in $K$ repräsentative Intervallbreiten $\{Q_1, ..., Q_K\}$, ein vorgebbarer Wertebereich für die Spezifizierung der Wahrscheinlichkeiten in $N$ repräsentative Wahrscheinlichkeitszustände $\{P_1, ..., P_N\}$ unterteilt wird und Zuordnungsvorschriften angegeben werden, die jeder Intervallbreite $R$ ein $Q_k$ ($1 \leq k \leq K$) und jeder Wahrscheinlichkeit ein $P_n$ ($1 \leq n \leq N$) zuordnen, in einem zweiten Schritt die Enkodierung oder Dekodierung der binären Zustände erfolgt, indem die Berechnung der im Enkodier- bzw Dekodierprozess abzuleitenden neuen Intervallbreite unter Verwendung von einer repräsentativen Intervallbreite $Q_k$ ($1 \leq k \leq K$) und einem repräsentativen Wahrscheinlichkeitszustand $P_n$ ($1 \leq n \leq N$) durch von Multiplikation und Division verschiedene arithmetische Operationen durchgeführt wird, wobei die repräsentative Intervallbreite $Q_k$ durch das zugrundeliegende Basisintervall der Breite R und der repräsentative Wahrscheinlichkeitszustand $P_n$ durch die dem zu enkodierenden oder zu dekodierendem Symbol zugrundeliegende Wahrscheinlichkeitsschätzung gemäß den angegebenen Zuordnungsvorschriften bestimmt werden.

Eine andere Ausführungsform ist dadurch gekennzeichnet, daß ausgehend von dem aktuell auszuwertenden Intervall mit Breite $R$ zur Bestimmung der zugeordneten Intervallbreite $Q_k$ ein Index *q_index* durch eine Schiebe- und Bitmaskierungsoperation angewendet auf die rechnerinterne/binäre Darstellung von R ermittelt wird.

Als vorteilhaft erweist es sich auch, wenn ausgehend von dem aktuell auszuwertenden Intervall mit Breite $R$ zur Bestimmung der zugeordneten Intervallbreite $Q_k$ ein Index *q_index* durch eine Schiebeoperation angewendet auf die rechnerinterne/binäre Darstellung von R und einem nachgeschalteten Zugriff auf eine Tabelle Qtab ermittelt wird, wobei die Tabelle Qtab die den durch Schiebeoperation vorquantisierten Werten von R entsprechenden Indizes von Intervallbreiten enthält.

Insbesondere erweist es sich als vorteilhaft, wenn die dem zu enkodierenden oder zu dekodierendem Symbol zugrundeliegende Wahrscheinlichkeitsschätzung mit Hilfe eines Indizes *p_state* einem Wahrscheinlichkeitszustand $P_n$ zugeordnet wird.

Es ist ebenfalls von Vorteil, wenn die Bestimmung der dem *LPS* entsprechenden Intervallbreite $R_{LPS}$ durch einen Zugriff auf eine Tabelle *Rtab* erfolgt, wobei die Tabelle Rtab die zu allen $K$ quantisierten Werten von $R$ und den $N$ verschiedenen Wahrscheinlichkeitszuständen korrespondierenden Werte der Intervallbreite $R_{LPS}$ als Produktwerte ($Q_k * P_n$) enthält. Der Rechenaufwand wird insbesondere dann reduziert, wenn die Bestimmung der dem LPS entsprechenden Intervallbreite $R_{LPS}$ durch einen Zugriff auf die Tabelle Rtab erfolgt, wobei zur Auswertung der Tabelle der Quantisierungsindex *q_index* und der Index des Wahrscheinlichkeitszustand *p_state* verwendet wird.

Es ist weiterhin vorgesehen, daß bei dem Verfahren für die $N$ verschiedenen repräsentativen Wahrscheinlichkeitszustände Übergangsregeln vorgegeben werden, wobei die Übergangsregeln angeben, welcher neue Zustand ausgehend von dem aktuell enkodierten oder dekodierten Symbol für das nächste zu kodierende oder dekodierende Symbol verwendet wird. Hierbei erweist es sich von Vorteil, wenn eine Tabelle *Next_State_LPS* angelegt wird, welche zu dem Index *n* des aktuell gegebenen Wahrscheinlichkeitszustands $P_n$ den Index *m* des neuen Wahrscheinlichkeitszustands $P_m$ bei Auftreten eines least probable symbol (LPS) enthält, und/oder eine Tabelle *Next_State_MPS* angelegt wird, welche zu dem Index *n* des aktuell gegebenen Wahrscheinlichkeitszustands $P_n$ den Index *m* des neuen Wahrscheinlichkeitszustands $P_m$ bei Auftreten eines most probable symbol (MPS) enthält.

Eine Optimierung des Verfahrens zur tabellengestützten binären arithmetischen Enkodierung und Dekodierung wird insbesondere dadurch erreicht, daß die zu allen *K* Intervallbreiten und zu allen *N* verschiedenen Wahrscheinlichkeitszustands korrespondierenden Werte der Intervallbreite $R_{LPS}$ als Produktwerte ($Q_k$ * $P_n$) in einer Tabelle *Rtab* abgelegt werden.

Eine weitere Optimierung erreicht man, wenn die Anzahl *K* der Quantisierungswerte und/oder die Anzahl *N* der repräsentativen Zustände in Abhängigkeit der vorgegebenen Genauigkeit der Kodierung und/oder in Abhängigkeit des verfügbaren Speicherplatzes gewählt werden.

Eine Enkodierung umfasst beispielsweise folgende Schritte:

1. Bestimmung des LPS
2. Quantisierung von R:

```
q_index = Qtab [R>>q]
```

3. Bestimmung von $R_{LPS}$ und R :

```
R_LPS = Rtab [q_index, p_state]

R = R - R_LPS
```

4. Berechnung des neuen Teilintervalls:

```
if (bit = LPS) then
     L ← L + R
     R ← R_LPS
     p_state ← Next_State_LPS [p_state]
     if (p_state = 0) then va1MPS ← 1 - va1MPS
else
     p_state ← Next_State_MPS [p_state],
```

5. Renormalisierung von L und R, Schreiben von Bits, wobei

| | |
|---|---|
| **q_index** | den Index eines aus Qtab ausgelesenen Quantisierungswertes, |
| **p_state** | den aktuellen Zustand, |
| **$R_{LPS}$** | die dem LPS entsprechende Intervallbreite und |
| **va1MPS** | das dem MPS entsprechende Bit |

beschreiben.

Die Dekodierung umfasst beispielsweise folgende Schritte:

1. Bestimmung des LPS
2. Quantisierung von R:

```
q_index = Qtab [R>>q]
```

3. Bestimmung von $R_{LPS}$ und R :

```
RLPS = Rtab [q_index, p_state]

R = R - RLPS
```

4. Bestimmung von bit, je nach Lage des Teilintervalls:

```
if (V ≥ R) then
bit ← LPS
V ← V - R
R ← RLPS
     if (P_state = 0) va1MPS ← 1 - va1MPS
     p_state ← Next_State_LPS [p_state]
else

    bit ← MPS
    p_state ← Next_State_MPS [p_state]
```

5. Renormalisierung von R, Auslesen eines Bits und Aktualisierung von V, wobei

**q_index** den Index eines aus Qtab ausgelesenen Quantisierungswertes,
**p_state** den aktuellen Zustand,
**$R_{LPS}$** die dem LPS entsprechende Intervallbreite,
**va1MPS** das dem MPS entsprechende Bit und
**V** einen Wert aus dem Innern des aktuellen Teilintervalls

beschreiben.

In einem anderen Verfahren ist vorgesehen, daß bei der Enkodierung und/oder Dekodierung die Berechnung des Quantisierungsindex *q_index* im zweiten Teilschritt nach der Berechnungsvorschrift erfolgt:

```
q_index = (R>>q) & Qmask
```

wobei Qmask eine in Abhängigkeit von K geeignet gewählte Bitmaske darstellt.

Bei Vorliegen einer uniformen Wahrscheinlichkeitsverteilung lässt sich eine weitere Optimierung des Verfahrens zur tabellengestützten binären arithmetischen Enkodierung und Dekodierung erreichen, indem

- bei der Enkodierung nach dem ersten speziellen Ausführungsbeispiel die Teilschritte 1 bis 4 nach folgender Berechnungsvorschrift erfolgen:

```
R ← R>>1
if (bit = 1) then
     L ← L + R,
```

oder
die Teilschritte 1 bis 4 der Enkodierung nach dem ersten speziellen Ausführungsbeispiel gemäß folgender Berechnungsvorschrift erfolgen:

```
L ← L << 1
if (bit = 1) then
    L ← L + R
```

und bei der letzten Alternative die Renormalisierung (Teilschritt 5 nach dem ersten speziellen Ausführungsbeispiel) mit verdoppelten Entscheidungsschwellwerten erfolgt und keine Verdoppelung von L und R vorgenommen wird, bei der Dekodierung nach dem zweiten speziellen Ausführungsbeispiel die Teilschritte 1 bis 4 nach folgender Berechnungsvorschrift erfolgen:

```
R ← R >> 1
if (V ≥ R) then
    bit ← 1
    V ← V - R
else
    bit ← 0,
```

oder die Teilschritte 1 bis 5 der Dekodierung nach dem zweiten speziellen Ausführungsbeispiel gemäß folgender Berechnungsschrift ausgeführt werden:

1. Auslesen eines Bits und Aktualisierung von V
2. Bestimmung von bit, je nach Lage des Teilintervalls:

```
if (V ≥ R) then
    bit ← 1
    V ← V - R
else
bit ← 0.
```

Es erweist sich weiterhin als vorteilhaft, wenn die Initialisierung der Wahrscheinlichkeitsmodelle in Abhängigkeit eines Quantisierungsparameters SliceQP und vorgegebener Modellparameter m und n erfolgt, wobei SliceQP den am Beginn eines Slices vorgegebenen Quantisierungsparamter und m und n die Modellparameter beschreiben.
Ebenso ist es vorteilhaft, wenn die Initialisierung der Wahrscheinlichkeitsmodelle folgende Schritte umfasst:

1. preState = min(max(1,((m * SliceQP)>>4)+n),2*N)
2.

```
if (preState <= N) then
        p_state = N+1 - preState
        valMPS = 0
else
        p_state = preState - N
        valMPS = 1,
```

wobei valMPS das dem MPS entsprechende Bit, SliceQP den am Beginn eines Slices vorgegebenen Quantisierungsparamter und m und n die Modellparameter beschreiben.

Eine Anordnung zur arithmetischen Enkodierung und Dekodierung von binären Zuständen umfasst mindestens einen Prozessor, der (die) derart eingerichtet ist (sind), dass ein Verfahren zur arithmetischen Enkodierung und Dekodierung durchführbar ist, wobei in einem ersten Schritt ein vorgebbarer Wertebereich für die Spezifizierung der Intervallbreite $R$ in $K$ repräsentative Intervallbreiten $\{Q_1, ..., Q_k\}$, ein vorgebbarer Wertebereich für die Spezifizierung der Wahrscheinlichkeiten in $N$ repräsentative Wahrscheinlichkeitszustände $\{P_1, ..., P_N\}$ unterteilt wird und Zuordnungsvorschriften angegeben werden, die jeder Intervallbreite R ein $Q_k$ ($1 \leq k \leq K$) und jeder Wahrscheinlichkeit ein $P_n$ ($1 \leq n \leq N$) zuordnen, in einem zweiten Schritt die Enkodierung oder Dekodierung der binären Zustände erfolgt, indem die Berechnung der im Enkodier- bzw Dekodierprozess abzuleitenden neuen Intervallbreite unter Verwendung von einer repräsentativen Intervallbreite $Q_k$ ($1 \leq k \leq K$) und einem repräsentativen Wahrscheinlichkeitszustand $P_n$ ($1 \leq n \leq N$) durch von Multiplikation und Division verschiedene arithmetische Operationen durchgeführt wird, wobei die repräsentative Intervallbreite $Q_k$ durch das zugrundeliegende Basisintervall der Breite R und der repräsentative Wahrscheinlichkeitszustand $P_n$ durch die dem zu enkodierenden oder zu dekodierendem Symbol zugrundeliegende Wahrscheinlichkeitsschätzung gemäß den angegebenen Zuordnungsvorschriften bestimmt werden.

Ein Computerprogramm zur arithmetischen Enkodierung und Dekodierung von binären Zuständen ermöglicht es einem Computer, nachdem es in den Speicher des Computers geladen worden ist, ein Verfahren zur arithmetischen Enkodierung und Dekodierung durchzuführen, wobei in einem ersten Schritt ein vorgebbarer Wertebereich für die Spezifizierung der Intervallbreite $R$ in K repräsentative Intervallbreiten $\{Q_1, ..., Q_k\}$, ein vorgebbarer Wertebereich für die Spezifizierung der Wahrscheinlichkeiten in $N$ repräsentative Wahrscheinlichkeitszustände $\{P_1, ..., P_N\}$ unterteilt wird und Zuordnungsvorschriften angegeben werden, die jeder Intervallbreite $R$ ein $Q_k$ ($1 \leq k \leq K$) und jeder Wahrscheinlichkeit ein $P_n$ ($1 \leq n \leq N$) zuordnen, in einem zweiten Schritt die Enkodierung oder Dekodierung der binären Zustände erfolgt, indem die Berechnung der im Enkodier- bzw Dekodierprozess abzuleitenden neuen Intervallbreite unter Verwendung von einer repräsentativen Intervallbreite $Q_k$ ($1 \leq k \leq K$) und einem repräsentativen Wahrscheinlichkeitszustand $P_n$ ($1 \leq n \leq N$) durch von Multiplikation und Division verschiedene arithmetische Operationen durchgeführt wird, wobei die repräsentative Intervallbreite $Q_k$ durch das zugrundeliegende Basisintervall der Breite R und der repräsentative Wahrscheinlichkeitszustand $P_n$ durch die dem zu enkodierenden oder zu dekodierendem Symbol zugrundeliegende Wahrscheinlichkeitsschätzung gemäß den angegebenen Zuordnungsvorschriften bestimmt werden.

Beispielsweise können solche Computerprogramme (gegen Gebühr oder unentgeltlich, frei zugänglich oder passwortgeschützt) downloadbar in einem Daten- oder Kommunikationsnetz bereitgestellt werden. Die so bereitgestellten Computerprogramme können dann durch ein Verfahren nutzbar gemacht werden, bei dem ein Computerprogramm nach Anspruch 22 aus einem Netz zur Datenübertragung wie beispielsweise aus dem Internet auf eine an das Netz angeschlossene Datenverarbeitungseinrichtung heruntergeladen wird.

Zur Durchführung eines Verfahrens zur arithmetischen Enkodierung und Dekodierung von binären Zuständen wird vorteilhafterweise ein computerlesbares Speichermedium genutzt, auf dem ein Programm gespeichert ist, das es einem Computer ermöglicht, nachdem es in den Speicher des Computers geladen worden ist, ein Verfahren zur arithmetischen Enkodierung und Dekodierung durchzuführen, wobei in einem ersten Schritt ein vorgebbarer Wertebereich für die Spezifizierung der Intervallbreite $R$ in $K$ repräsentative Intervallbreiten $\{Q_1, ..., Q_K\}$, ein vorgebbarer Wertebereich für die Spezifizierung der Wahrscheinlichkeiten in $N$ repräsentative Wahrscheinlichkeitszustände $(P_1, ..., P_N\}$ unterteilt wird und Zuordnungsvorschriften angegeben werden, die jeder Intervallbreite R ein $Q_k$ ($1 \leq k \leq K$) und jeder Wahrscheinlichkeit ein $P_n$ ($1 \leq n \leq N$) zuordnen, in einem zweiten Schritt die Enkodierung oder Dekodierung der binären Zustände erfolgt, indem die Berechnung der im Enkodier- bzw Dekodierprozess abzuleitenden neuen Intervallbreite unter Verwendung von einer repräsentativen Intervallbreiten $Q_k$ ($1 \leq k \leq K$) und einem repräsentativen Wahrscheinlichkeitszustand $P_n$ ($1 \leq n \leq N$) durch von Multiplikation und Division verschiedene arithmetische Operationen durchgeführt wird, wobei die repräsentative Intervallbreite $Q_k$ durch das zugrundeliegende Basisintervall der Breite R und der repräsentative Wahrscheinlichkeitszustand $P_n$ durch die dem zu enkodierenden oder zu dekodierendem Symbol zugrundeliegende Wahrscheinlichkeitsschätzung gemäß den angegebenen Zuordnungsvorschriften bestimmt werden.

Die Erfindung wird nachfolgend anhand eines in der Zeichnung dargestellten Ausführungsbeispiels näher erläutert.

Es zeigen:

- Figur 1 Darstellung der wesentlichen Operationen zur binären arithmetischen Kodierung;
- Figur 2 Modifiziertes Schema zur tabellengestützten arithmetischen Enkodierung;
- Figur 3 Prinzip der tabellengestützten arithmeti- schen Decodierung;
- Figur 4 Prinzip der En- bzw. Dekodierung für binäre Daten mit uniformer verteilung;
- Figur 5 Alternative Realisierung der En- bzw. Dekodierung für binäre Daten mit uniformer Verteilung.
- Figur 6 Initialisierung der Wahrscheinlichkeits- modelle in Abhängigkeit eines Quantisierungsparameters SliceQP und vorgegebener Modellparameter m und n

Zunächst einmal soll jedoch der theoretische Hintergrund etwas näher erläutert werden:

Tabellengestützte Wahrscheinlichkeitsschätzung

Wie oben bereits näher erläutert, beruht die Wirkungsweise der arithmetischen Kodierung auf einer möglichst guten Schätzung der Auftrittswahrscheinlichkeit der zu kodierenden Symbole. Um eine Adaption an instationäre Quellenstatistiken zu ermöglichen, muss diese Schätzung im Laufe des Kodierungsprozesses aktualisiert werden. In der Regel werden hierzu herkömmlicherweise Verfahren verwendet, die mit Hilfe skalierter Häufigkeitszähler der kodierten Ereignisse operieren [17]. Bezeichnen $c_{LPS}$ und $c_{MPS}$ Zähler für die Auftrittshäufigkeiten von *LPS* und *MPS,* so lässt sich mittels dieser Zähler die Schätzung

$$P_{LPS} = \frac{c_{LPS}}{c_{LPS} + c_{MPS}} \qquad (1)$$

vornehmen und damit die in Figur 1 skizzierte Operation der Intervallunterteilung ausführen. Für praktische Zwecke nachteilig ist die in Gleichung (1) erforderliche Division. Häufig ist es jedoch zweckmäßig und erforderlich, bei Überschreitung eines vorgegebenen Schwellwerts $C_{max}$ des Gesamtzählers $c_{Total} = c_{MPS} + c_{LPS}$ eine Reskalierung der Zählerstände vorzunehmen. (Man beachte in diesem Zusammenhang, dass bei einer b-bit-Darstellung von *L* und *R* die kleinste Wahrscheinlichkeit, die noch korrekt dargestellt werden kann, $2^{-b+2}$ beträgt, so dass zur Vermeidung der Unterschreitung dieser unteren Grenze gegebenenfalls eine Reskalierung der Zählerstände erforderlich ist.) Bei geeigneter Wahl von $C_{max}$ lassen sich die reziproken Werte von $c_{Total}$ tabellieren, so dass die in Gleichung (1) erforderliche Division durch einen Tabellenzugriff sowie eine Multiplikations- und Schiebeoperation ersetzt werden kann. Um jedoch auch diese arithmetischen Operationen zu vermeiden, wird in der vorliegenden Erfindung ein vollständig tabellengestütztes Verfahren zur Wahrscheinlichkeitsschätzung verwendet.

Zu diesem Zweck werden vorab in einer Trainingsphase repräsentative Wahrscheinlichkeitszustände $\{P_k \mid 0 \leq k < N_{max}\}$ ausgewählt, wobei die Auswahl der Zustände einerseits von der Statistik der zu kodierenden Daten und andererseits von der Nebenbedingung der vorgegebenen Maximalanzahl $N_{max}$ von Zuständen abhängt. Zusätzlich werden Übergangsregeln definiert, die angegeben, welcher neue Zustand ausgehend von dem aktuell kodierten Symbol für das nächste zu kodierende Symbol verwendet werden soll. Diese Übergangsregeln werden in Form zweier Tabellen bereitgestellt: $\{Next_State_LPS_k \mid 0 \leq k < N_{max}\}$ und $\{Next_State_MPS_k \mid 0 \leq k < N_{max}\}$, wobei die Tabellen für den Index n des aktuell gegebenen Wahrscheinlichkeitszustands $P_n$ den Index m des neuen Wahrscheinlichkeitszustands $P_m$ bei Auftreten eines LPS bzw. MPS liefern. Hervorzuheben sei an dieser Stelle, dass zur Wahrscheinlichkeitsschätzung im arithmetischen Enkoder bzw. Dekoder, so wie er hier vorgeschlagen wird, keine explizite Tabellierung der Wahrscheinlichkeitszustände notwendig ist. Vielmehr werden die Zustände nur anhand ihrer entsprechenden Indizes implizit adressiert, wie im nachfolgenden Abschnitt beschrieben. Zusätzlich zu den Übergangsregeln muss spezifiert werden, bei welchen Wahrscheinlichkeitszuständen der Wert des LPS und MPS vertauscht werden muss. In der Regel wird es nur einen solchen ausgezeichneten Zustand geben, der dann anhand seines Indizes *p_state* identifiziert werden kann.

Tabellengestützte Intervallunterteilung

Figur 2 zeigt das modifizierte Schema zur tabellengestützten arithmetischen Kodierung, wie sie hier vorgeschlagen wird. Nach Bestimmung des LPS wird zunächst die gegebene Intervallbreite R mittels einer tabellierten Abbildung *Qtab* und einer geeigneten Schiebeoperation (um *q* bit) auf einen quantisierten Wert *Q* abgebildet. Alternativ kann die Quantisierung in Sonderfällen auch ohne Zuhilfenahme einer tabellierten Abbildung Qtab nur mit Hilfe einer Kombination von Schiebe- und Maskierungsoperationen ausgeführt werden. In der Regel wird hier eine relativ grobe Quantisierung auf $K = 2...8$ repräsentative Werte vorgenommen. Auch hier erfolgt, ähnlich wie im Fall der Wahrscheinlichkeitsschätzung, keine explizite Bestimmung von *Q*; vielmehr wird nur ein Index *q_index* auf Q übergeben. Dieser Index wird nun zusammen mit dem Index *p_state* zur Charakterisierung des aktuellen Wahrscheinlichkeitszustands für die Bestimmung der Intervallbreite $R_{LPS}$ verwendet. Dazu wird der entsprechende Eintrag der Tabelle Rtab verwendet. Dort sind die zu allen *K* quantisierten Werten von R und $N_{max}$ verschiedenen Wahrscheinlichkeitszuständen korrespondierenden $K \cdot N_{max}$ Produktwerte $R \times P_{LPS}$ als Ganzzahlwerte mit einer Genauigkeit von i.a. b-2 Bits abgelegt. Für praktische Implementierungen ist hier eine Möglichkeit gegeben, zwischen dem Speicherbedarf für die Tabellengröße und der arithmetischen Genauigkeit, die letztlich auch die Effizienz der Kodierung bestimmt; abzuwägen. Beide Zielgrößen werden durch die Granularität der Repräsentierung von R und $P_{LPS}$ bestimmt.

Im vierten Schritt der Figur 2 ist gezeigt, wie die Aktualisierung des Wahrscheinlichkeitszustands *p_state* in Abhängigkeit des gerade kodierten Ereignisses bit vorgenommen wird. Hier werden die im vorigen Abschnitt "Tabellengestützte Wahrscheinlichkeitsschätzung" bereits erwähnten Übergangstabellen *Next_State_LPS* und *Next_State_MPS* benutzt. Diese Operationen entsprechen dem in Figur 1 im 4. Schritt angegebenen, aber nicht näher spezifizierten Aktualisierungsprozeß.

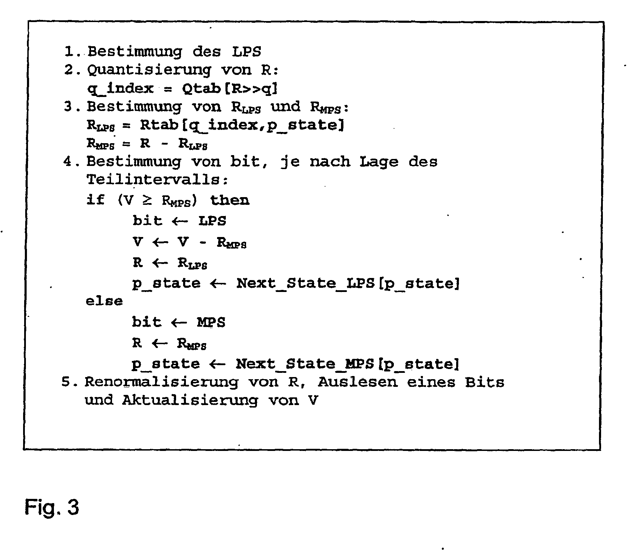

Figur 3 zeigt das korrespondierende Ablaufschema der tabellengestützten arithmetischen Dekodierung. Zur Charakterisierung des aktuellen Teilintervalls wird im Dekoder die Intervallbreite R und ein Wert V verwendet. Letzterer liegt im Innern des Teilintervalls und wird mit jedem gelesenen Bit sukzessive verfeinert. Wie aus der Figur 3 hervorgeht, werden die Operationen zur Wahrscheinlichkeitsschätzung und Bestimmung der Intervallbreite *R* entsprechend denen des Enkoders nachgeführt.

Kodierung mit uniformer Wahrscheinlichkeitsverteilung In Anwendungen, in denen z. B. vorzeichenbehaftete Werte kodiert werden sollen, deren Wahrscheinlichkeitsverteilung symmetrisch um die Null angeordnet ist, wird man zur Kodierung der Vorzeicheninformation in der Regel von einer Gleichverteilung ausgehen können. Da diese Information einerseits mit in den arithmetischen Bitstrom eingebettet werden soll, es anderseits aber nicht sinnvoll ist, für den Fall einer Wahrscheinlichkeit von $P \approx 0.5$ den immer noch relativ aufwändigen Apparat der tabellengestützten Wahrscheinlichkeitsschätzung und Intervallunterteilung zu benutzen, wird vorgeschlagen für diesen Spezialfall, optional eine gesonderte Enkoder-/Dekoder Prozedur zu benutzen, die sich wie folgt darstellt.

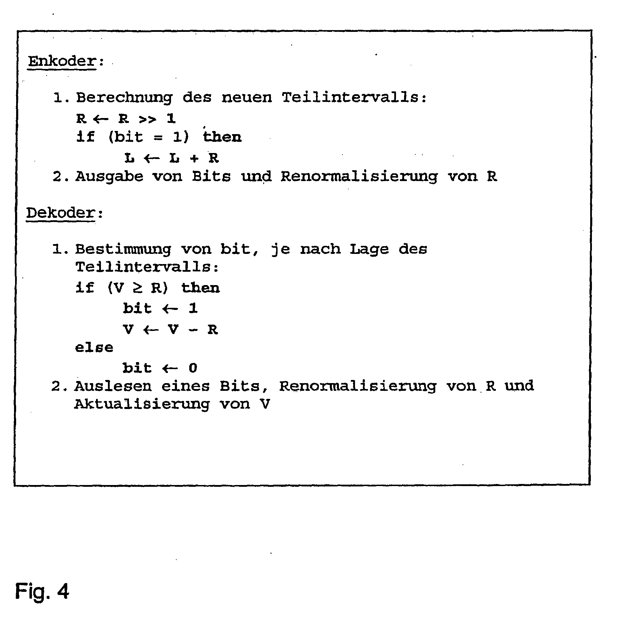

Im Enkoder lässt sich für diesen Spezialfall die Intervallbreite des neuen Teilintervalls durch eine einfache Schiebeoperation entsprechend einer Halbierung der Breite des Ausgangsintervalls R bestimmen. Je nach Wert des zu kodierenden Bits wird dann die obere bzw. untere Hälfte von *R* als neues Teilintervall gewählt (vgl. Figur 4). Die anschließende Renormalisierung und Ausgabe von Bits erfolgt wie im obigen Fall der tabellengestützten Lösung.

Im entsprechenden Dekoder reduzieren sich die notwendigen Operationen darauf, das zu dekodierende Bit anhand des Werts von *V* relativ zur aktuellen Intervallbreite *R* durch eine einfache Vergleichsoperation zu bestimmen. In dem Fall, dass das dekodierte Bit gesetzt wird, ist *V* um den Betrag von *R* zu reduzieren. Wie in Figur 4 dargestellt, wird die Dekodierung durch die Renormalisierung und die Aktualisierung von V mit dem nächsten einzulesenden Bit abgeschlossen.

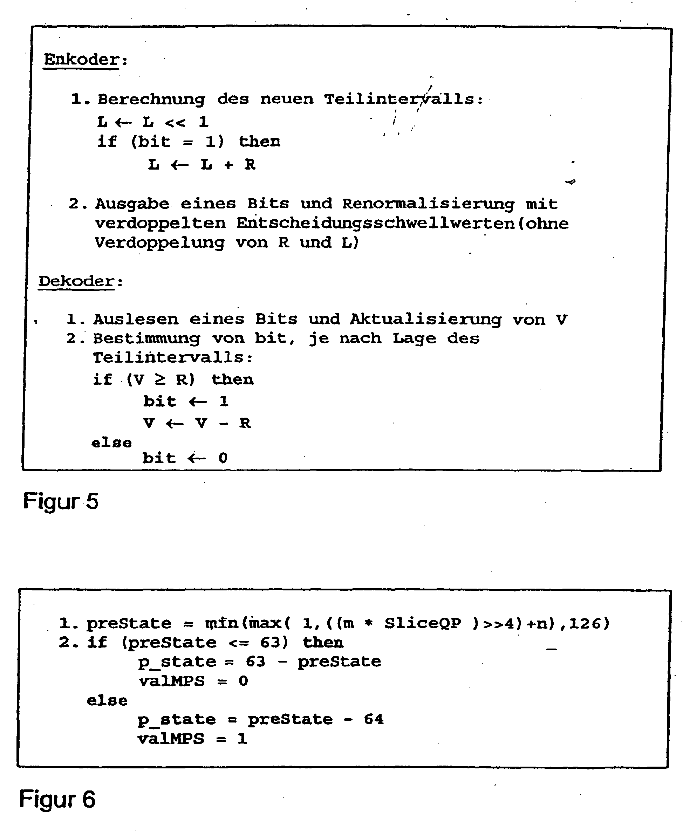

Eine alternative Realisierung der Kodierung von Ereignissen mit uniformer Wahrscheinlichkeitsverteilung ist in Figur 5 dargestellt. In dieser beispielhaften Implementierung wird die aktuelle Intervallbreite R nicht modifiziert. Stattdessen wird im Enkoder zunächst V durch eine Schiebeoperation verdoppelt. Je nach Wert des zu kodierenden Bits wird dann, ähnlich wie im vorigen Beispiel, die obere bzw. untere Hälfte von R als neues Teilintervall gewählt (vgl. Figur 5). Die anschließende Renormalisierung und Ausgabe von Bits erfolgt wie im obigen Fall der tabellengestützten Lösung, mit dem Unterschied, dass die Verdoppelung von *R* und *L* nicht ausgeführt wird und die entsprechenden Vergleichsoperationen mit verdoppelten Schwellwerten ausgeführt werden.

Im entsprechenden Dekoder der alternativen Realisierung wird zunächst ein Bit ausgelesen und *V* aktualisiert. Der zweite Schritt vollzieht sich in derselben Art und Weise wie Schritt 1 in Figur 4, d.h., das zu dekodierende Bit wird anhand des Werts von *V* relativ zur aktuellen Intervallbreite *R* durch eine einfache Vergleichsoperation bestimmt, und in dem Fall, in dem das dekodierte Bit gesetzt wird, ist *V* um den Betrag von *R* zu reduzieren (vgl. Figur 5).

Adressierung und Initialisierung der Wahrscheinlichkeitsmodelle

Jedes Wahrscheinlichkeitsmodell, wie es in der vorgestellten Erfindung Verwendung findet, wird mit Hilfe zweier Parameter gekennzeichnet: 1) der Index *p_state,* der den Wahrscheinlichkeitszustand des LPS charakterisiert, und 2) der Wert *valMPS* des MPS. Jede dieser beiden Größen muss zu Anfang der Enkodierung bzw. Dekodierung einer abgeschlossenen Kodiereinheit (in Anwendungen der Videokodierung etwa ein Slice) initialisiert werden. Die Initialisierungswerte können dabei aus Steuerinformationen, etwa dem Quantisierungsparameter (eines Slices) abgeleitet werden, wie es in Figur 6 beispielhaft dargestellt ist.

Vorwärtsgesteuerter Initialisierungsprozeß

Eine weitere Möglichkeit der Anpassung der Startverteilungen der Modelle wird durch folgende Methode bereitgestellt. Um eine bessere Anpassung der Initialisierungen der Modelle zu gewährleisten, kann im Enkoder eine Auswahl von vorgebenen Startwerten der Modelle bereitgestellt werden. Diese Modelle können zu Gruppen von Startverteilungen zusammengefasst und mit Indizes adressiert werden, so dass im Enkoder die adaptive Auswahl einer Gruppe von Startwerten erfolgt und dem Dekoder in Form eines Indizes als Seiteninformation übermittelt wird. Diese Methode wird als vorwärtsgesteuerter Initialisierungsprozeß bezeichnet.

Schließlich wird noch mal abschließend auf die Möglichkeit hingewiesen, dass die Anzahl von möglichen Quantisierungsindizes und/oder die Anzahl der Wahrscheinlichkeitszustände in Abhängigkeit der vorgegebenen Genauigkeit der Kodierung und/oder in Abhängigkeit des verfügbaren Speicherplatzes gewählt sein kann.Die Wahrscheinlichkeitsschätzung der Zustände kann mittels einer endlichen Zustandsmaschine (finite state machine; FSM) erfolgen. Zudem ist es möglich, dass die Generierung der Wahrscheinlichkeitszustände offline erfolgt. Schließlich kann vorgesehen sein, dass die Auswahl der Zustände von der Statistik der zu kodierenden Daten und/oder von der Anzahl der Zustände abhängt.

**Quellennachweis**

[1] T. Wiegand, G. Sullivan, "Draft Text of Final Draft International Standard (FDIS) of Joint Video Specification (ITU-T Rec. H.264 | ISO/IEC 14496-10 AVC)", JVT-G050, March 2003.
[2] D. A. Huffman, "A Method for Construction of Minimum Redundancy code", Proc. IRE, Vol. 40, pp. 1098-1101, 1952.
[3] I. H. Witten, R. M. Neal, J. G. Cleary, "Arithmetic Coding for Data Compression", Communication of the ACM, Vol. 30, No. 6, pp. 520-540, 1987.
[4] G. G. Langdon, J. Rissanen, "A Simple General Binary Source code", IEEE Transactions on Information Theory, Vol. 28, pp. 800-803, 1982.
[5] C. E. Shannon, "A Mathematical Theory of Communication", Bell Syst. Tech. Journal, vol. 27, pp. 379-423, 623-656, 1948.
[6] P. Elias, in "Information Theory and Coding", N. Abramson (Ed.), New York, Mc-Gra-Hill, 1963.
[7] J. Rissanen, "Generalized Kraft Inequality and Arithmetic Coding", IBM J. Res. Develop., Vol. 20, pp. 198-203. 1976.
[8] R. C. Pasco, "Source Coding and Algorithms for Fast Data Compression", Ph. D. Dissertation, Stanford University, USA, 1976.
[9] G. G. Langdon, "An Introduction to Arithmetic Coding", IBM J. Res. Develop., Vol. 28, pp. 135-149, 1984.
[10] A. Moffat, R. M. Neal, I. H. Witten, "Arithmetic Coding Revisited", Proc. IEEE Data Compression Conference, Snowbird (USA), pp. 202-211, 1996.
[11] J. Rissanen, K. M. Mohiuddin, "A Multiplication-Free Multialphabet Arithmetic Arithmetic Code", IEEE Trans, on Communication, Vol. 37, pp. 93-98, 1989.
[12] W. B. Pennebaker, J. L. Mitchell, G. G. Langdon, R. B. Arps, "An Overview of the Basic Principles of the Q-Coder Adaptive Binary Arithmetic Coder", IBM J. Res. Develop., Vol. 32, pp. 717-726, 1988.
[13] P. G. Howard, J. S. Vitter, "Practical Implementations of Arithmetic Coding", in "Image and Text Compression", J. Storer (Ed.), Norwell (USA), Kluwer, 1992.
[14] L. Huynh, A. Moffat, "A Probability-Ratio Approach to Approximate Binary Arithmetic Coding", IEEE Trans. on Information Theory, Vol. 43, pp. 1658-1662, 1997.
[15] D. Chevion, E. D. Karnin, E. Walach, "High-Efficiency, Multiplication Free Approximation of Arithmetic Coding", Proc. IEEE Data Compression Conferenc, Snowbird (USA), pp. 43-52, 1991.
[16] G. Feygin, P. G. Gulak, P. Chow, "Minimizing Excess Code Length and VLSI Complexity in the Multiplication Free Approximation of Arithmetic Coding", Inform. Proc. Manag., vol. 30, pp. 805-816, 1994.
[17] D. L. Duttweiler, Ch. Chamzas, "Probability Estimation in Arithmetic and Adaptive-Huffman Entropy Coders", IEEE Trans. on Image Processing, Vol. 4, pp. 237- 246, 1995.

**Patentansprüche**

**1.** Verfahren zur arithmetischen Enkodierung von zu enkodierenden Symbolen mit binärem Zustand auf der Grundlage einer aktuellen Intervallbreite (R) eines aktuellen Intervalls und, für adaptive Wahrscheinlichkeitsmodelle mit nicht-uniformer Wahrscheinlichkeitsverteilung, einer eine Wahrscheinlichkeitsschätzung für das jeweilige zu enkodierende Symbol darstellenden Wahrscheinlichkeit, wobei die Wahrscheinlichkeit durch einen Wahrscheinlichkeitsindex zur Adressierung eines Wahrscheinlichkeitszustands aus einer Mehrzahl von repräsentativen Wahrscheinlichkeitszuständen repräsentiert ist, wobei das Verfahren folgende Schritte aufweist:

für zu enkodierende Symbole mit einem nicht-adaptiven Wahrscheinlichkeitsmodell mit uniformer Wahrscheinlichkeitsverteilung, Enkodieren eines jeweils zu enkodierenden Symbols (bit) durch

Verdoppeln eines aktuellen Intervallaufsatzpunkts (L) eines aktuellen Intervalls, um einen neuen Intervallaufsatzpunkt zu erhalten,
Auswählen einer oberen oder unteren Hälfte des aktuellen Intervalls als ein neues Intervall durch Erhöhen des neuen Intervallaufsatzpunkts um eine aktuelle Intervallbreite (R) je nach Wert des jeweils zu enkodierenden Symbols (bit), und
Renormalisierung der neuen Intervallbreite und des neuen Intervallaufsatzpunkts unter Verwendung einer Skalierungsoperation und ersten Schwellwerten und Ausgeben eines Bits in dem Fall einer Skalierungsoperation, und

für zu enkodierende Symbole mit einem adaptiven Wahrscheinlichkeitsmodell mit einer nicht-uniformen Wahrscheinlichkeitsverteilung, Enkodieren eines aktuell zu enkodierenden Symbols durch

tabellengestützte Unterteilung der aktuellen Intervallbreite (R) basierend auf einem aktuellen Wahrscheinlichkeitsindex, um einen Teilintervallbreitenwert ($R_{LPS}$) eines Teilintervalls des aktuellen Intervalls für einen weniger wahrscheinlichen Wert (LPS) des aktuell zu enkodierenden Symbols (bit) zu erhalten, durch

Abbilden der aktuellen Intervallbreite (R) auf einen Quantisierungsindex (q_index) aus einer Mehrzahl von repräsentativen Quantisierungsindizes; und
Zugreifen unter Verwendung des Quantisierungsindex (q_index) und des aktuellen Wahrscheinlichkeitsindex auf eine Intervallteilungstabelle, um den Teilintervallbreitenwert ($R_{LPS}$) zu erhalten;

tabellengestützte Schätzung einer Auftrittswahrscheinlichkeit eines als nächstes zu enkodierenden Symbols unter Verwendung von zwei Tabellen, die Übergangsregeln von dem aktuellen Wahrscheinlichkeitsindex zu einem neuen Wahrscheinlichkeitsindex bereitstellen, und von denen eine für den Fall vorgesehen ist, dass das aktuelle zu enkodierende Symbol den weniger wahrscheinlichen Wert (LPS) hat, und die andere für den Fall, dass das aktuelle zu enkodierende Symbol den wahrscheinlicheren Wert (MPS) hat, und
Auswählen eines Teils des aktuellen Intervalls mit dem Teilintervallbreitenwert ($R_{LPS}$) als ein neues Intervall durch Einstellen einer neuen Intervallbreite auf den Teilintervallbreitenwert ($R_{LPS}$) und Erhöhen eines Intervallaufsatzpunkts (L) um eine Differenz zwischen der aktuellen Intervallbreite (R) und dem Teilintervallbreitenwert ($R_{LPS}$), oder des übrigen Teils des aktuellen Intervalls als das neue Intervall durch Einstellen der neuen Intervallbreite auf die Differenz zwischen der aktuellen Intervallbreite (R) und dem Teilintervallbreitenwert ($R_{LPS}$) und Beibehalten des Intervallaufsatzpunkts (L), abhängig von dem aktuell zu enkodierenden Symbol, und
Renormalisierung der neuen Intervallbreite und des Intervallaufsatzpunkts unter Verdopplung der neuen Intervallbreite und des Intervallaufsatzpunkts und unter Verwendung einer Skalierungsoperation und von zweiten Schwellwerten, gegenüber denen die ersten Schwell-werte verdoppelt sind, und Ausgeben eines Bits bei jeder Skalierungsoperation.

**2.** Verfahren nach Anspruch 1, das ferner das Umstellen eines den wahrscheinlicheren Zustand anzeigenden Wertes von einem ursprünglich angezeigten Zustand auf den binären Zustand des aktuell zu enkodierenden Symbols aufweist, wenn der neue Wahrscheinlichkeitsindex einem vorbestimmten Wahrscheinlichkeitsindex gleicht und das zu enkodierende Symbol einen von dem ursprünglichen angezeigten Zustand unterschiedlichen binären Zustand aufweist.

**3.** Verfahren zur arithmetischen Dekodierung von enkodierten Symbolen mit binärem Zustand auf der Grundlage einer aktuellen Intervallbreite (R) und, für adaptive Wahrscheinlichkeitsmodelle mit nicht-uniformer Wahrscheinlichkeitsverteilung, einer eine Wahrscheinlichkeitsschätzung für das enkodierte Symbol darstellenden Wahrscheinlichkeit, wobei die Wahrscheinlichkeit durch einen Wahrscheinlichkeitsindex eines Wahrscheinlichkeitszustands aus einer Mehrzahl von repräsentativen Wahrscheinlichkeitszuständen repräsentiert ist, wobei das Verfahren folgenden Schritt aufweist:

für enkodierte Symbole mit einem nicht-adaptiven Wahrscheinlichkeitsmodell mit uniformer Wahrscheinlichkeitsverteilung, Dekodieren eines jeweils enkodierten Symbols (bit) durch

Auslesen eines Bits und Aktualisierung eines im Inneren eines Teilintervalls eines aktuellen Intervalls liegenden Werts (V) durch Verfeinerung mit dem ausgelesenen Bit,
Bestimmen eines Werts des jeweils enkodierten Symbols (bit) durch eine Vergleichsoperation zwischen dem aktualisierten Wert (V) und einer aktuellen Intervallbreite (R) des aktuellen Intervalls, und
Reduzieren des aktualisierten Werts (V) um die aktuelle Intervallbreite je nach dem bestimmten Wert, und

für enkodierte Symbole mit einem adaptiven Wahrscheinlichkeitsmodell mit einer nicht-uniformen Wahrscheinlichkeitsverteilung, Dekodieren des aktuellen enkodierten Symbols (bit)durch

tabellengestützte Unterteilung eine aktuellen Intervallbreite (R) basierend auf einem aktuellen Wahrscheinlichkeitsindex, um einen Teilintervallbreitenwert ($R_{LPS}$) eines Teilintervalls des aktuellen Intervalls für einen weniger wahrscheinlichen Wert (LPS) des aktuellen enkodierten Symbols (bit) zu erhalten, durch Abbilden der aktuellen Intervallbreite (R) auf einen Quantisierungsindex (q_index) aus einer Mehrzahl von repräsentativen Quantisierungsindizes; und
Zugreifen unter Verwendung des Quantisierungsindex (q_index) und des aktuellen Wahrscheinlichkeitsindex auf eine Intervallteilungstabelle, um den Teilintervallbreitenwert ($R_{LPS}$) zu erhalten;

tabellengestützte Schätzung einer Auftrittswahrscheinlichkeit eines nächsten enkodierten Symbols unter Verwendung von zwei Tabellen, die Übergangsregeln von dem aktuellen Wahrscheinlichkeitsindex zu einem neuen Wahrscheinlichkeitsindex bereitstellen, und von denen eine für den Fall vorgesehen ist, dass das aktuelle enkodierte Symbol (bit) den weniger wahrscheinlichen Wert (LPS) hat, und die andere für den Fall, dass das aktuelle enkodierte Symbol (bit) den wahrscheinlicheren Wert (MPS) hat, und
Bestimmen eines Werts des aktuellen enkodierten Symbols (bit) durch eine Vergleichsoperation zwischen einem im Inneren eines Teilintervalls des aktuellen Intervalls liegenden Werts (V) einerseits und einer Differenz aus der aktuellen Intervallbreite (R) des aktuellen Intervalls und dem Teilintervallbreitenwert ($R_{LPS}$) andererseits, und
Einstellen einer neuen Intervallbreite auf den Teilintervallbreitenwert ($R_{LPS}$) und Reduzieren des im Inneren eines Teilintervalls des aktuellen Intervalls liegenden Werts (V) um die Differenz zwischen der aktuellen Intervallbreite (R) und dem Teilintervallbreitenwert ($R_{LPS}$), oder Einstellen der neuen Intervallbreite auf die Differenz zwischen der aktuellen Intervallbreite (R) und dem Teilintervallbreitenwert ($R_{LPS}$) und Beibehalten des im Inneren eines Teilintervalls des aktuellen Intervalls liegenden Werts (V), abhängig von der Vergleichsoperation, und
Renormalisierung der neuen Intervallbreite (R), Auslesen eines Bits und Aktualisierung des im Inneren eines Teilintervalls des aktuellen Intervalls liegenden Werts (V) durch Verfeinerung mit dem ausgelesenen Bit.

**4.** Verfahren nach Anspruch 3, das ferner das Umstellen eines den wahrscheinlicheren Zustand des aktuell enkodierten Symbols anzeigenden Wertes von einem ursprünglich angezeigten Zustand auf einen unterschiedlichen binären Zustand aufweist, wenn der neue Wahrscheinlichkeitsindex einem vorbestimmten Wahrscheinlichkeitsindex gleicht und der im Inneren des neuen Teilintervalls liegende Wert größer gleich einer Differenz aus der aktuellen Intervallbreite und dem Teilintervallbreitewert ist.

**5.** Verfahren nach einem der vorhergehenden Ansprüche, bei dem die aktuelle Intervallbreite mit einer Genauigkeit von b Bits und der von der Intervallteilungstabelle erhaltene Teilintervallbreitenwert mit einer Genauigkeit von b-2 Bits dargestellt ist.

**6.** Verfahren nach einem der vorhergehenden Ansprüche, bei dem die Aktualisierung der Wahrscheinlichkeitsschätzung das Nachschlagen, mit dem aktuellen Wahrscheinlichkeitsindex, in einer der zwei Tabellen (*Next_State_LPS, Next_State_MPS*) aufweist, um den neuen Wahrscheinlichkeitsindex zu erhalten, wobei die Auswahl der Tabelle davon abhängt, ob das aktuell enkodierte Symbol den weniger wahrscheinlichen (LPS) oder den wahrscheinlicheren Wert (MPS) aufweist.

**7.** Anordnung zur arithmetischen Enkodierung eines zu enkodierenden Symbols mit binärem Zustand auf der Grundlage einer aktuellen Intervallbreite R und, für adaptive Wahrscheinlichkeitsmodelle mit nicht-uniformer Wahrscheinlichkeitsverteilung, einer eine Wahrscheinlichkeitsschätzung für das zu enkodierende Symbol darstellenden Wahrscheinlichkeit, wobei die Wahrscheinlichkeit durch einen Wahrscheinlichkeitsindex zur Adressierung eines Wahrscheinlichkeitszustands aus einer Mehrzahl von repräsentativen Wahrscheinlichkeitszuständen repräsentiert ist, wobei die Vorrichtung folgendes Merkmal aufweist:

einer Einrichtung zum, für zu enkodierende Symbole mit einem nicht-adaptiven Wahrscheinlichkeitsmodell mit uniformer Wahrscheinlichkeitsverteilung, Enkodieren eines jeweils zu enkodierenden Symbols (bit) durch

Verdoppeln eines aktuellen Intervallaufsatzpunkts (L) eines aktuellen Intervalls, um einen neuen Intervallaufsatzpunkt zu erhalten,
Auswählen einer oberen oder unteren Hälfte des aktuellen Intervalls als ein neues Intervall durch Erhöhen des neuen Intervallaufsatzpunkts um eine aktuelle Intervallbreite (R) je nach Wert des jeweils zu enkodierenden Symbols (bit), und
Renormalisierung der neuen Intervallbreite und des neuen Intervallaufsatzpunkts unter Verwendung einer Skalierungsoperation und ersten Schwellwerten und Ausgeben eines Bits in dem Fall einer Skalierungsoperation, und

einer Einrichtung zum, für zu enkodierende Symbole mit einem adaptiven Wahrscheinlichkeitsmodell mit einer nicht-uniformen Wahrscheinlichkeitsverteilung, Enkodieren eines aktuell zu enkodierenden Symbols durch

tabellengestützte Unterteilung der aktuellen Intervallbreite (R) basierend auf einem aktuellen Wahrscheinlichkeitsindex, um einen Teilintervallbreitenwert ($R_{LPS}$) eines Teilintervalls des aktuellen Intervalls für einen weniger wahrscheinlichen Wert (LPS) des aktuell zu enkodierenden Symbols (bit) zu erhalten, durch

Abbilden der aktuellen Intervallbreite (R) auf einen Quantisierungsindex (q_index) aus einer Mehrzahl von repräsentativen Quantisierungsindizes; und
Zugreifen unter Verwendung des Quantisierungsindex (q_index) und des aktuellen Wahrscheinlichkeitsindex auf eine Intervalltei - lungstabelle, um den Teilintervallbreitenwert ($R_{LPS}$) zu erhalten;

tabellengestützte Schätzung einer Auftrittswahrscheinlichkeit eines als nächstes zu enkodierenden Symbols unter Verwendung von zwei Tabellen, die Übergangsregeln von dem aktuellen Wahrscheinlichkeitsindex zu einem neuen Wahrscheinlichkeitsindex bereitstellen, und von denen eine für den Fall vorgesehen ist, dass das aktuelle zu enkodierende Symbol den weniger wahrscheinlichen Wert (LPS) hat, und die andere für den Fall, dass das aktuelle zu enkodierende Symbol den wahrscheinlicheren Wert (MPS) hat, und
Auswählen eines Teils des aktuellen Intervalls mit dem Teilintervallbreitenwert ($R_{LPS}$) als ein neues Intervall durch Einstellen einer neuen Intervallbreite auf den Teilintervallbreitenwert ($R_{LPS}$) und Erhöhen eines Intervallaufsatzpunkts (L) um eine Differenz zwischen der aktuellen Intervallbreite (R) und dem Teilintervallbreitenwert ($R_{LPS}$), oder des übrigen Teils des aktuellen Intervalls als das neue Intervall durch Einstellen der neuen Intervallbreite auf die Differenz zwischen der aktuellen Intervallbreite (R) und dem Teilintervallbreitenwert ($R_{LPS}$) und Beibehalten des Intervallaufsatzpunkts (L), abhängig von dem aktuell zu enkodierenden Symbol, und
Renormalisierung der neuen Intervallbreite und des Intervallaufsatzpunkts unter Verdopplung der neuen Intervallbreite und des Intervallaufsatzpunkts und unter Verwendung einer Skalierungsoperation und von zweiten Schwellwerten, gegenüber denen die ersten Schwellwerte verdoppelt sind, und Ausgeben eines Bits bei jeder Skalierungsoperation.

**8.** Anordnung zur arithmetischen Dekodierung eines enkodierten Symbols mit binärem Zustand auf der Grundlage einer aktuellen Intervallbreite R und, für adaptive Wahrscheinlichkeitsmodelle mit nicht-uniformer Wahrscheinlichkeitsverteilung, einer eine Wahrscheinlichkeitsschätzung für das enkodierte Symbol darstellenden Wahrscheinlichkeit, wobei die Wahrscheinlichkeit durch einen Wahrscheinlichkeitsindex zur Adressierung eines Wahrscheinlichkeitszustands aus einer Mehrzahl von repräsentativen Wahrscheinlichkeitszuständen repräsentiert ist, wobei die Vorrichtung folgendes Merkmal aufweist:

einer Einrichtung zum, für enkodierte Symbole mit einem nicht-adaptiven Wahrscheinlichkeitsmodell mit uniformer Wahrscheinlichkeitsverteilung, Dekodieren eines jeweils enkodierten Symbols (bit) durch

Auslesen eines Bits und Aktualisierung eines im Inneren eines Teilintervalls eines aktuellen Intervalls liegenden Werts (V) durch Verfeinerung mit dem ausgelesenen Bit,
Bestimmen eines Werts des jeweils enkodierten Symbols (bit) durch eine Vergleichsoperation zwischen dem aktualisierten Wert (V) und einer aktuellen Intervallbreite (R) des aktuellen Intervalls, und
Reduzieren des aktualisierten Werts (V) um die aktuelle Intervallbreite je nach dem bestimmten Wert, und

einer Einrichtung zum, für enkodierte Symbole mit einem adaptiven Wahrscheinlichkeitsmodell mit einer nicht-uniformen Wahrscheinlichkeitsverteilung, Dekodieren des aktuellen enkodierten Symbols (bit)durch

tabellengestützte Unterteilung eine aktuellen Intervallbreite (R) basierend auf einem aktuellen Wahrscheinlichkeitsindex, um einen Teilintervallbreitenwert ($R_{LPS}$) eines Teilintervalls des aktuellen Intervalls für einen weniger wahrscheinlichen Wert (LPS) des aktuellen enkodierten Symbols (bit) zu erhalten, durch

Abbilden der aktuellen Intervallbreite (R) auf einen Quantisierungsindex (q_index) aus einer Mehrzahl von repräsentativen Quantisierungsindizes; und
Zugreifen unter Verwendung des Quantisierungsindex (q_index) und des aktuellen Wahrscheinlichkeitsindex auf eine Intervallteilungstabelle, um den Teilintervallbreitenwert ($R_{LPS}$) zu erhalten;

tabellengestützte Schätzung einer Auftrittswahrscheinlichkeit eines nächsten enkodierten Symbols unter Verwendung von zwei Tabellen, die Übergangsregeln von dem aktuellen Wahrscheinlichkeitsindex zu einem neuen Wahrscheinlichkeitsindex bereitstellen, und von denen eine für den Fall vorgesehen ist, dass das aktuelle enkodierte Symbol (bit) den weniger wahrscheinlichen Wert (LPS) hat, und die andere für den Fall, dass das aktuelle enkodierte Symbol (bit) den wahrscheinlicheren Wert (MPS) hat, und
Bestimmen eines Werts des aktuellen enkodierten Symbols (bit) durch eine Vergleichsoperation zwischen einem im Inneren eines Teilintervalls des aktuellen Intervalls liegenden Werts (V) einerseits und einer Differenz aus der aktuellen Intervallbreite (R) des aktuellen Intervalls und dem Teilintervallbreitenwert ($R_{LPS}$) andererseits, und
Einstellen einer neuen Intervallbreite auf den Teilintervallbreitenwert ($R_{LPS}$) und Reduzieren des im Inneren eines Teilintervalls des aktuellen Intervalls liegenden Werts (V) um die Differenz zwischen der aktuellen Intervallbreite (R) und dem Teilintervallbreitenwert ($R_{LPS}$), oder Einstellen der neuen Intervallbreite auf die Differenz zwischen der aktuellen Intervallbreite (R) und dem Teilintervallbreitenwert ($R_{LPS}$) und Beibehalten des im Inneren eines Teilintervalls des aktuellen Intervalls liegenden Werts (V), abhängig von der Vergleichsoperation, und
Renormalisierung der neuen Intervallbreite (R), Auslesen eines Bits und Aktualisierung des im Inneren eines Teilintervalls des aktuellen Intervalls liegenden Werts (V) durch Verfeinerung mit dem ausgelesenen Bit.

**9.** Computerprogramm, das es einem Computer ermöglicht, nachdem es in den Speicher des Computers geladen worden ist, ein Verfahren gemäß einem der Ansprüche 1 bis 6 durchzuführen.

**10.** Computerlesbares Speichermedium, auf dem ein Programm gespeichert ist, das es einem Computer ermöglicht, nachdem es in den Speicher des Computers geladen worden ist, ein Verfahren gemäß einem der Ansprüche 1 bis 6 durchzuführen.

**Claims**

**1.** A method for arithmetically encoding symbols to be encoded having a binary state based on a current interval width (R) of a current interval and, for adaptive probability models having a non-uniform probability distribution, a probability representing a probability estimation for the respective symbol to be encoded, wherein the probability is represented by a probability index for addressing a probability state from a plurality of representative probability states, wherein the method comprises the following steps:

for symbols to be encoded with a non-adaptive probability model having a uniform probability distribution, encoding a respective symbol (bit) to be encoded by:

doubling a current interval attaching point (L) of a current interval to obtain a new interval attaching point, selecting an upper or lower half of the current interval as a new interval by increasing the new interval attaching point by a current interval width (R), in dependence on the value of the respective symbol (bit) to be encoded, and
renormalizing the new interval width and the new interval attaching point using a scaling operation and first threshold values, and outputting a bit in the case of a scaling operation, and

for symbols to be encoded with an adaptive probability model having a non-uniform probability distribution, encoding a current symbol to be encoded by:

table-aided division of the current interval width (R) based on a current probability index to obtain a partial interval width value ($R_{LPS}$) of a partial interval of the current interval for a less probable value (LPS) of the current symbol (bit) to be encoded, by:

mapping the current interval width (R) to a quantization index (q_index) from a plurality of representative quantization indices; and
accessing an interval division table using the quantization index (q_index) and the current probability index to obtain the partial interval width value ($R_{LPS}$);

table-assisted estimation of an occurrence probability of a symbol to be encoded next using two tables which provide transition rules from the current probability index to a new probability index, and of which one is provided for the case that the current symbol to be encoded has the less probable value (LPS) and the other one for the case that the current symbol to be encoded has the more probable value (MPS), and selecting a part of the current interval with the partial interval width value ($R_{LPS}$) as a new interval by setting a new interval width to the partial interval width value ($R_{LPS}$) and increasing an interval attaching point (L) by a difference between the current interval width (R) and the partial interval width value ($R_{LPS}$), or the remaining part of the current interval as the new interval by setting the new interval width to the difference between the current interval width (R) and the partial interval width value ($R_{LPS}$), and maintaining the interval attaching point (L), in dependence on the current symbol to be encoded, and
renormalizing the new interval width and the interval attaching point using doubling the new interval width and the interval attaching point and using a scaling operation and second threshold values compared to which the first threshold values are doubled, and outputting a bit in each scaling operation.

**2.** The method of claim 1, further comprising adjusting a value indicative of the more probable state from a state originally indicated to the binary state of the current symbol to be encoded, when the new probability index is like a predetermined probability index and the symbol to be encoded has a binary state different from the state originally indicated.

**3.** A method for arithmetically decoding encoded symbols having a binary state based on a current interval width (R) and, for adaptive probability models having a non-uniform probability distribution, a probability representing a probability estimation for the encoded symbol, wherein the probability is represented by a probability index of a probability state from a plurality of representative probability states, wherein the method comprises the following step:

for encoded symbols of a non-adaptive probability model having a uniform probability distribution, decoding a respective encoded symbol (bit) by:

reading out a bit and updating a value (V) within a partial interval of a current interval by refining the bit read out,
determining a value of the respective encoded symbol (bit) by a comparative operation between the updated value (V) and a current interval width (R) of the current interval, and
reducing the updated value (V) by the current interval width, in dependence on the value determined, and

for encoded symbols of an adaptive probability model having a non-uniform probability distribution, decoding the current encoded symbol (bit) by:

table-aided division of a current interval width (R) based on a current probability index to obtain a partial interval width value ($R_{LPS}$) of a partial interval of the current interval for a less probable value (LPS) of the current encoded symbol (bit) by:

mapping the current interval width (R) to a quantization index (q_index) from a plurality of representative quantization indices; and
accessing an interval division table using the quantization index (q_index) and the current probability index to obtain a partial interval width value;

table-aided estimation of an occurrence probability of a next encoded symbol using two tables which provide transition rules from the current probability index to a new probability index, and of which one is provided for the case that the current encoded symbol (bit) has the less probable value (LPS) and the other one for the case that the current encoded symbol has the more probable value (MPS), and
determining a value of the current encoded symbol (bit) by a comparative operation between a value (V) within a partial interval of the current interval on the one hand and a difference between the current interval width (R) of the current interval and the partial interval width value ($R_{LPS}$) on the other hand, and
setting a new interval width to the partial interval width value ($R_{LPS}$) and reducing the value (V) within a partial interval of the current interval by the difference between the current interval width (R) and the partial interval width value ($R_{LPS}$), or setting the new interval width to the difference between the current interval width (R) and the partial interval width value ($R_{LPS}$) and maintaining the value (V) within a partial interval of the current interval, in dependence on the comparative operation, and
renormalizing the new interval width (R), reading out a bit, and updating the value (V) within a partial interval of the current interval by refining using the bit read out.

**4.** The method of claim 3, further comprising adjusting a value indicative of the more probable state of the current encoded symbol from a state originally indicated to a different binary state, when the new probability index is like a predetermined probability index and the value within the new partial interval is larger than or equal to a difference of the current interval width and partial interval width value.

5. The method of one of the preceding claims, wherein the current interval width is represented with an accuracy of b bits, and the partial interval width value obtained from the interval division table is represented with an accuracy of b-2 bits.

6. The method of one of the preceding claims, wherein updating the probability estimation comprises looking up, with the current probability index, in one of the two tables (Next_State_LPS, Next_State_MPS) to obtain a new probability index, wherein the selection of the table is dependent on whether the current encoded symbol has the less probable value (LPS) or the more probable value (MPS).

7. An arrangement for arithmetically encoding a symbol to be encoded having a binary state based on a current interval width R and, for adaptive probability models having a non-uniform probability distribution, a probability representing a probability estimation for the symbol to be encoded, wherein the probability is represented by a probability index for addressing a probability state from a plurality of representative probability states, wherein the device comprises:

means for, for symbols to be encoded with a non-adaptive probability model having a uniform probability distribution, encoding a respective symbol (bit) to be encoded by:

doubling a current interval attaching point (L) of a current interval to obtain a new interval attaching point, selecting an upper or lower half of the current interval as a new interval by increasing the new interval attaching point by a current interval width (R), in dependence on the value of the respective symbol (bit) to be encoded, and
renormalizing the new interval width and the new interval attaching point using a scaling operation and first threshold values, and outputting a bit in the case of a scaling operation, and

means for, for symbols to be encoded with an adaptive probability model having a non-uniform probability distribution, encoding a current symbol to be encoded by:

table-aided division of the current interval width (R) based on a current probability index to obtain a partial interval width value ($R_{LPS}$) of a partial interval of the current interval for a less probable value (LPS) of the current symbol (bit) to be encoded, by:

mapping the current interval width (R) to a quantization index (q_index) from a plurality of representative quantization indices; and
accessing an interval division table using the quantization index (q_index) and the current probability index to obtain the partial interval width value ($R_{LPS}$);

table-assisted estimation of an occurrence probability of a symbol to be encoded next using two tables which provide transition rules from the current probability index to a new probability index, and of which one is provided for the case that the current symbol to be encoded has the less probable value (LPS) and the other one for the case that the current symbol to be encoded has the more probable value (MPS), and selecting a part of the current interval with the partial interval width value ($R_{LPS}$) as a new interval by setting a new interval width to the partial interval width value ($R_{LPS}$) and increasing an interval attaching point (L) by a difference between the current interval width (R) and the partial interval width value ($R_{LPS}$), or the remaining part of the current interval as the new interval by setting the new interval width to the difference between the current interval width (R) and the partial interval width value ($R_{LPS}$), and maintaining the interval attaching point (L), in dependence on the current symbol to be encoded, and
renormalizing the new interval width and the interval attaching point using doubling the new interval width and the interval attaching point and using a scaling operation and second threshold values compared to which the first threshold values are doubled, and outputting a bit in each scaling operation.

8. An arrangement for arithmetically decoding an encoded symbol having a binary state based on a current interval width R and, for adaptive probability models having a non-uniform probability distribution, a probability representing a probability estimation for the encoded symbol, wherein the probability is represented by a probability index for addressing a probability state from a plurality of representative probability states, wherein the device comprises:

means for, for encoded symbols of a non-adaptive probability model having a uniform probability distribution, decoding a respective encoded symbol (bit) by:

reading out a bit and updating a value (V) within a partial interval of a current interval by refining the bit read out,
determining a value of the respective encoded symbol (bit) by a comparative operation between the updated value (V) and a current interval width (R) of the current interval, and
reducing the updated value (V) by the current interval width, in dependence on the value determined, and

means for, for encoded symbols of an adaptive probability model having a non-uniform probability distribution, decoding the current encoded symbol (bit) by:

table-aided division of a current interval width (R) based on a current probability index to obtain a partial interval width value ($R_{LPS}$) of a partial interval of the current interval for a less probable value (LPS) of the current encoded symbol (bit) by:

mapping the current interval width (R) to a quantization index (q_index) from a plurality of representative quantization indices; and
accessing an interval division table using the quantization index (q_index) and the current probability index to obtain a partial interval width value;

table-aided estimation of an occurrence probability of a next encoded symbol using two tables which provide transition rules from the current probability index to a new probability index, and of which one is provided for the case that the current encoded symbol (bit) has the less probable value (LPS) and the other one for the case that the current encoded symbol has the more probable value (MPS), and
determining a value of the current encoded symbol (bit) by a comparative operation between a value (V) within a partial interval of the current interval on the one hand and a difference between the current interval width (R) of the current interval and the partial interval width value ($R_{LPS}$) on the other hand, and
setting a new interval width to the partial interval width value ($R_{LPS}$) and reducing the value (V) within a partial interval of the current interval by the difference between the current interval width (R) and the partial interval width value ($R_{LPS}$), or setting the new interval width to the difference between the current interval width (R) and the partial interval width value ($R_{LPS}$) and maintaining the value (V) within a partial interval of the current interval, in dependence on the comparative operation, and
renormalizing the new interval width (R), reading out a bit, and updating the value (V) within a partial interval of the current interval by refining using the bit read out

**9.** A computer program which enables a computer after it has been loaded into the storage of the computer to perform a method of one of claims 1 to 6.

**10.** A computer-readable storage medium on which a program is stored which enables a computer after it has been loaded into the storage of the computer to perform a method of one of claims 1 to 6.

**Revendications**

**1.** Procédé de codage arithmétique de symboles à coder avec un état binaire sur base d'une largeur d'intervalle actuelle (R) d'un intervalle actuel et, pour des modèles de probabilité adaptatifs à répartition de probabilité non uniforme, une probabilité représentant une estimation de probabilité du symbole à coder respectif, la probabilité étant représentée par un indice de probabilité pour l'adressage d'un état de probabilité parmi une pluralité d'états de probabilité représentatifs, le procédé présentant les étapes suivantes consistant à:

pour les symboles à coder avec un modèle de probabilité non adaptatif à répartition de probabilité uniforme, coder un symbole (bit) à coder respectif

en doublant un point d'appui d'intervalle (L) actuel pour obtenir un nouveau point d'appui d'intervalle,
en sélectionnant une moitié supérieure ou inférieure de l'intervalle actuel comme nouvel intervalle en augmentant le nouveau point d'appui d'intervalle d'une largeur d'intervalle actuelle (R) selon la valeur du symbole (bit) à coder respectif, et
en renormalisant la nouvelle largeur d'intervalle et le nouveau point d'appui d'intervalle à l'aide d'une opération d'échelonnement et de premières valeurs de seuil et sortir un bits dans le cas d'une opération d'échelonnement, et

pour les symboles à coder avec un modèle de probabilité adaptatif à répartition de probabilité non uniforme, coder un symbole à coder actuel

en subdivisant avec assistance d'un tableau la largeur d'intervalle actuelle (R) sur base d'un indice de probabilité actuel, pour obtenir une valeur de largeur ($R_{LPS}$) d'un intervalle partiel de l'intervalle actuel pour une valeur moins probable (LPS) du symbole (bit) à coder actuel,

en réproduisant la largeur d'intervalle actuelle (R) sur un indice de quantification (q_index) parmi une pluralité d'indices de quantification représentatifs; et
en accédant à l'aide de l'indice de quantification (q_index) et de l'indice de probabilité actuel à un tableau de division d'intervalle, pour obtenir la valeur de largeur d'intervalle partielle ($R_{LPS}$);

en estimant avec assistance d'un tableau une probabilité d'apparition d'un symbole à coder suivant à l'aide de deux tableaux mettant à disposition des règles de transition de l'indice de probabilité actuel à un nouvel indice de probabilité, et dont l'un est prévu pour le cas où le symbole à coder actuel présente la valeur moins probable (LPS) et l'autre pour le cas où le symbole à coder actuel présente la valeur plus probable (MPS), et
en sélectionnant une partie de l'intervalle actuel avec la valeur de largeur d'intervalle partielle ($R_{LPS}$) comme nouvel intervalle en réglant une nouvelle largeur d'intervalle sur la valeur de largeur d'intervalle partielle ($R_{LPS}$) et en augmentant un point d'appui d'intervalle (L) d'une différence entre la largeur d'intervalle actuelle (R) et la valeur de largeur d'intervalle partielle ($R_{LPS}$), ou de la partie restante de l'intervalle actuel comme nouvel intervalle en réglant la nouvelle largeur d'intervalle sur la différence entre la largeur d'intervalle actuelle (R) et la valeur de largeur d'intervalle partielle ($R_{LPS}$) et en maintenant le point d'appui d'intervalle (L), en fonction du symbole à coder actuel, et
en renormalisant la nouvelle largeur d'intervalle et le point d'appui d'intervalle en doublant la nouvelle largeur d'intervalle et le point d'appui d'intervalle et à l'aide d'une opération d'échelonnement et de deuxièmes valeurs de seuil par rapport auxquelles les premières valeurs de seuil sont doublées, et sortir un bit à chaque opération d'échelonnement.

**2.** Procédé selon la revendication 1, présentant par ailleurs la conversion d'une valeur indiquant l'état plus probable d'un état affiché initial à l'état binaire du symbole à coder actuel lorsque le nouvel indice de probabilité est égal à un indice de probabilité prédéterminé et le symbole à coder présente un état binaire différent de l'état affiché initialement.

**3.** Procédé de décodage arithmétique de symboles codés à état binaire sur base d'une largeur d'intervalle actuelle (R) et, pour les modèles de probabilité adaptatifs à répartition de probabilité non uniforme, une probabilité représentant une estimation de probabilité pour le symbole codé, la probabilité étant représentée par un indice de probabilité d'un état de probabilité parmi une pluralité d'états de probabilité représentatifs, le procédé présentant l'étape suivante consistant à:

pour les symboles codés avec un modèle de probabilité non adaptatif à répartition de probabilité uniforme, décoder un symbole (bit) codé respectif

en lissant un bit et en mettant à jour une valeur (V) située à l'intérieur d'un intervalle partiel d'un intervalle actuel par raffinement par le bit lu,
en déterminant une valeur du symbole (bit) codé respectif par une opération de comparaison entre la valeur mise à jour (V) et une largeur d'intervalle actuelle (R) de l'intervalle actuel, et
en réduisant la valeur mise à jour (V) de la largeur d'intervalle actuelle selon la valeur déterminée, et

pour les symboles codés avec un modèle de probabilité adaptatif à répartition non uniforme, décoder le symbole (bit) codé actuel

en subdivisant avec assistance de tableaux une largeur d'intervalle (R) sur base d'un indice de probabilité actuel, pour obtenir une valeur de largeur d'intervalle partielle ($R_{LPS}$) d'un intervalle partiel de l'intervalle actuel pour une valeur moins probable (LPS) du symbole (bit) codé actuel

en reproduisant la largeur d'intervalle actuelle (R) sur un indice de quantification (q_index) parmi une pluralité d'indices de quantification représentatifs; et
en accédant à l'aide de l'indice de quantification (q_index) et de l'indice de probabilité actuel à un tableau de division d'intervalle, pour obtenir la valeur de largeur d'intervalle partielle ($R_{LPS}$);

en estimant avec assistance par tableaux une probabilité d'apparition d'un symbole codé suivant à l'aide de deux tableaux qui mettent à disposition des règles de transition de l'indice de probabilité actuel à un nouvel indice de probabilité, et dont l'un est prévu pour le cas où le symbole (bit) codé actuel présente la valeur la moins probable (LPS), et l'autre pour le cas où le symbole (bit) codé actuel présente la valeur plus probable (MPS), et
en déterminant une valeur du symbole (bit) codé actuel par une opération de comparaison entre une valeur (V) située à l'intérieur d'un intervalle partiel de l'intervalle actuel, d'une part, et une différence entre la largeur (R) de l'intervalle actuel et la valeur de largeur d'intervalle partielle ($R_{LPS}$), d'autre part, et
en réglant une nouvelle largeur d'intervalle sur la valeur de largeur d'intervalle partielle ($R_{LPS}$) et en réduisant la valeur (V) située à l'intérieur d'un intervalle partiel de l'intervalle actuel de la différence entre la largeur d'intervalle actuelle (R) et la valeur de largeur d'intervalle partielle ($R_{LPS}$), ou en réglant la nouvelle largeur d'intervalle sur la différence entre la largeur d'intervalle actuelle (R) et la valeur de largeur d'intervalle partielle ($R_{LPS}$) et en maintenant la valeur (V) située à l'intérieur d'un intervalle partiel de l'intervalle actuel, en fonction de l'opération de comparaison, et
en renormalisant la nouvelle largeur d'intervalle (R), en lisant un bit et en mettant à jour la valeur (V) située à l'intérieur d'un intervalle partiel de l'intervalle actuel par raffinement par le bit lu.

**4.** Procédé selon la revendication 3, présentant par ailleurs la conversion d'une valeur indiquant l'état plus probable du symbole codé actuel d'un état affiché initialement à un état binaire différent lorsque le nouvel indice de probabilité est égal à un indice de probabilité prédéterminé et que la valeur située à l'intérieur du nouvel intervalle partiel est supérieure ou égale à une différence entre la largeur d'intervalle actuelle et la valeur de largeur d'intervalle partielle.

**5.** Procédé selon l'une des revendications précédentes, dans lequel la largeur d'intervalle actuelle est représentée avec précision par b bits et la valeur de largeur d'intervalle partiel obtenue du tableau de division d'intervalle est représentée avec une précision de b-2 bits.

**6.** Procédé selon l'une des revendications précédentes, dans lequel la mise à jour de l'estimation de probabilité présente la consultation avec l'indice de probabilité actuel de l'un des deux tableaux (*Next_State_LPS*, *Next_State_MPS*), pour obtenir le nouvel indice de probabilité, la sélection du tableau étant fonction de si le symbole codé actuel présente la valeur moins probable (LPS) ou la valeur plus probable (MPS).

**7.** Aménagement de codage arithmétique de symboles à coder avec un état binaire sur base d'une largeur d'intervalle R et, pour des modèles de probabilité adaptatifs à répartition de probabilité non uniforme, une probabilité représentant une estimation de probabilité du symbole à coder respectif, la probabilité étant représentée par un indice de probabilité pour l'adressage d'un état de probabilité parmi une pluralité d'états de probabilité représentatifs, le dispositif présentant la caractéristique suivante:

un moyen pour coder, pour des symboles à coder avec un modèle de probabilité non adaptatif à répartition de probabilité uniforme, un symbole (bit) à coder respectif

en doublant un point d'appui d'intervalle (L) actuel d'un intervalle actuel pour obtenir un nouveau point d'appui d'intervalle,
en sélectionnant une moitié supérieure ou inférieure de l'intervalle actuel comme nouvel intervalle en augmentant le nouveau point d'appui d'intervalle d'une largeur d'intervalle actuelle (R) selon la valeur du symbole (bit) à coder respectif, et
en renormalisant la nouvelle largeur d'intervalle et le nouveau point d'appui d'intervalle à l'aide d'une opération d'échelonnement et de premières valeurs de seuil et sortir un bits dans le cas d'une opération d'échelonnement, et

un moyen pour coder, pour des symboles à coder avec un modèle de probabilité adaptatif à répartition de probabilité non uniforme, un symbole à coder actuel

en subdivisant avec assistance d'un tableau la largeur d'intervalle actuelle (R) sur base d'un indice de probabilité actuel, pour obtenir une valeur de largeur d'intervalle partielle ($R_{LPS}$) d'un intervalle partiel de l'intervalle actuel pour une valeur moins probable (LPS) du symbole (bit) à coder actuel,

en réproduisant la largeur d'intervalle actuelle (R) sur un indice de quantification (q_index) parmi une pluralité d'indices de quantification représentatifs; et
en accédant à l'aide de l'indice de quantification (q_index) et de l'indice de probabilité actuel à un tableau de division d'intervalle, pour obtenir la valeur de largeur d'intervalle partielle ($R_{LPS}$);

en estimant avec assistance d'un tableau une probabilité d'apparition d'un symbole à coder suivant à l'aide de deux tableaux mettant à disposition des règles de transition de l'indice de probabilité actuel à un nouvel indice de probabilité, et dont l'un est prévu pour le cas où le symbole à coder actuel présente la valeur moins probable (LPS) et l'autre pour le cas où le symbole à coder actuel présente la valeur plus probable (MPS), et
en sélectionnant une partie de l'intervalle actuel avec la valeur de largeur d'intervalle partielle ($R_{LPS}$) comme nouvel intervalle en réglant une nouvelle largeur d'intervalle sur la valeur de largeur d'intervalle partielle ($R_{LPS}$) et en augmentant un point d'appui d'intervalle (L) d'une différence entre la largeur d'intervalle actuelle (R) et la valeur de largeur d'intervalle partielle ($R_{LPS}$), ou de la partie restante de l'intervalle actuel comme nouvel intervalle en réglant la nouvelle largeur d'intervalle sur la différence entre la largeur d'intervalle actuelle (R) et la valeur de largeur d'intervalle partielle ($R_{LPS}$) et en maintenant le point d'appui d'intervalle (L), en fonction du symbole à coder actuel, et
en renormalisant la nouvelle largeur d'intervalle et le point d'appui d'intervalle en doublant la nouvelle largeur d'intervalle et le point d'appui d'intervalle et à l'aide d'une opération d'échelonnement et de deuxièmes valeurs de seuil par rapport auxquelles les premières valeurs de seuil sont doublées, et sortir un bit à chaque opération d'échelonnement.

**8.** Aménagement de décodage arithmétique d'un symbole codé à état binaire sur base d'une largeur d'intervalle actuelle R et, pour les modèles de probabilité adaptatifs à répartition de probabilité non uniforme, une probabilité représentant une estimation de probabilité pour le symbole codé, la probabilité étant représentée par un indice de probabilité pour l'adressage d'un état de probabilité parmi une pluralité d'états de probabilité représentatifs, le dispositif présentant la caractéristique suivante:

un moyen pour décoder, pour les symboles codés avec un modèle de probabilité non adaptatif à répartition de probabilité uniforme, un symbole (bit) codé respectif

en lissant un bit et en mettant à jour une valeur (V) située à l'intérieur d'un intervalle partiel d'un intervalle actuel par raffinement par le bit lu,
en déterminant une valeur du symbole (bit) codé respectif par une opération de comparaison entre la valeur mise à jour (V) et une largeur d'intervalle actuelle (R) de l'intervalle actuel, et
en réduisant la valeur mise à jour (V) de la largeur d'intervalle actuelle selon la valeur déterminée, et

un moyen pour décoder, pour des symboles codés avec un modèle de probabilité adaptatif à répartition non uniforme, le symbole (bit) codé actuel

en subdivisant avec assistance de tableaux une largeur d'intervalle actuelle (R) sur base d'un indice de probabilité actuel, pour obtenir une valeur de largeur d'intervalle partielle ($R_{LPS}$) d'un intervalle partiel de l'intervalle actuel pour une valeur moins probable (LPS) du symbole (bit) codé actuel

en reproduisant la largeur d'intervalle actuelle (R) sur un indice de quantification (q_index) parmi une pluralité d'indices de quantification représentatifs; et
en accédant à l'aide de l'indice de quantification (q_index) et de l'indice de probabilité actuel à un tableau de division d'intervalle, pour obtenir la valeur de largeur d'intervalle partielle ($R_{LPS}$);

en estimant avec assistance par tableaux une probabilité d'apparition d'un symbole codé suivant à l'aide de deux tableaux qui mettent à disposition des règles de transition de l'indice de probabilité actuel à un nouvel indice de probabilité, et dont l'un est prévu pour le cas où le symbole (bit) codé actuel présente la valeur moins probable (LPS), et l'autre pour le cas où le symbole (bit) codé actuel présente la valeur plus probable (MPS), et
en déterminant une valeur du symbole (bit) codé actuel par une opération de comparaison entre une valeur (V) située à l'intérieur d'un intervalle partiel de l'intervalle actuel, d'une part, et une différence entre la largeur d'intervalle actuelle (R) de l'intervalle actuel et la valeur de largeur d'intervalle partielle ($R_{LPS}$), d'autre part, et en réglant une nouvelle largeur d'intervalle sur la valeur de largeur d'intervalle partielle ($R_{LPS}$) et en réduisant la valeur (V) située à l'intérieur d'un intervalle partiel de l'intervalle actuel de la différence entre la largeur d'intervalle actuelle (R) et la valeur de largeur d'intervalle partielle ($R_{LPS}$), ou en réglant la nouvelle largeur d'intervalle sur la différence entre la largeur d'intervalle actuelle (R) et la valeur de largeur d'intervalle partielle ($R_{LPS}$) et en maintenant la valeur (V) située à l'intérieur d'un intervalle partiel de l'intervalle actuel, en fonction de l'opération de comparaison, et
en renormalisant la nouvelle largeur d'intervalle (R), en lisant un bit et en mettant à jour la valeur (V) située à l'intérieur d'un intervalle partiel de l'intervalle actuel par raffinement par le bit lu.

**9.** Programme d'ordinateur permettant à un ordinateur, après qu'il ait été chargé dans la mémoire de l'ordinateur, de réaliser un procédé selon l'une des revendications 1 à 6.

**10.** Support de mémoire lisible par ordinateur sur lequel est mémorisé un programme qui permet à un ordinateur, après qu'il ait été charge dans la mémoire de l'ordinateur, de réaliser un procédé selon l'une des revendications 1 à 6.

```
1. Bestimmung des LPS
2. Berechnung der Größen RLPS und RMPS:
   RLPS = R x PLPS
   RMPS = R - RLPS
3. Berechnung des neuen Teilintervalls:
   if (bit = LPS) then
         L ← L + RMPS
         R ← RLPS
   else
         R ← RMPS
4. Aktualisierung der Wahrscheinlichkeitsschätzung PLPS
5. Ausgabe von Bits und Renormalisierung von R
```

Fig. 1

```
1. Bestimmung des LPS
2. Quantisierung von R:
   q_index = Qtab[R>>q]
3. Bestimmung von RLPS und RMPS:
   RLPS = Rtab[q_index,p_state]
   RMPS = R - RLPS
4. Berechnung des neuen Teilintervalls:
   if (bit = LPS) then
         L ← L + RMPS
         R ← RLPS
         p_state ← Next_State_LPS[p_state]
   else
         R ← RMPS
         p_state ← Next_State_MPS[p_state]
```

Fig. 2

```
1. Bestimmung des LPS
2. Quantisierung von R:
   q_index = Qtab[R>>q]
3. Bestimmung von R_LPS und R_MPS:
   R_LPS = Rtab[q_index,p_state]
   R_MPS = R - R_LPS
4. Bestimmung von bit, je nach Lage des
   Teilintervalls:
   if (V ≥ R_MPS) then
        bit ← LPS
        V ← V - R_MPS
        R ← R_LPS
        p_state ← Next_State_LPS[p_state]
   else
        bit ← MPS
        R ← R_MPS
        p_state ← Next_State_MPS[p_state]
5. Renormalisierung von R, Auslesen eines Bits
   und Aktualisierung von V
```

Fig. 3

```
Enkoder:

  1. Berechnung des neuen Teilintervalls:
     R ← R >> 1
     if (bit = 1) then
         L ← L + R
  2. Ausgabe von Bits und Renormalisierung von R

Dekoder:

  1. Bestimmung von bit, je nach Lage des
     Teilintervalls:
     if (V ≥ R) then
         bit ← 1
         V ← V - R
     else
         bit ← 0
  2. Auslesen eines Bits, Renormalisierung von R und
     Aktualisierung von V
```

Fig. 4

```
Enkoder:

  1. Berechnung des neuen Teilintervalls:
     L ← L << 1
     if (bit = 1) then
          L ← L + R

  2. Ausgabe eines Bits und Renormalisierung mit
     verdoppelten Entscheidungsschwellwerten(ohne
     Verdoppelung von R und L)

Dekoder:

  1. Auslesen eines Bits und Aktualisierung von V
  2. Bestimmung von bit, je nach Lage des
     Teilintervalls:
     if (V ≥ R) then
          bit ← 1
          V ← V - R
     else
          bit ← 0
```

Figur 5

```
1. preState = min(max( 1,((m * SliceQP )>>4)+n),126)
2. if (preState <= 63) then
        p_state = 63 - preState
        valMPS = 0
   else
        p_state = preState - 64
        valMPS = 1
```

Figur 6

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- US 5592162 A


### In der Beschreibung aufgeführte Nicht-Patentliteratur


- **T. WIEGAND ; G. SULLIVAN.** Draft Text of Final Draft International Standard (FDIS) of Joint Video Specification (ITU-T Rec. H.264 | ISO/IEC 14496-10 AVC. *JVT-G050,* Marz 2003
- **D. A. HUFFMAN.** A Method for Construction of Minimum Redundancy code. *Proc. IRE,* 1952, vol. 40, 1098-1101
- **I. H. WITTEN ; R. M. NEAL ; J. G. CLEARY.** Arithmetic Coding for Data Compression. *Communication of the ACM,* 1987, vol. 30 (6), 520-540
- **G. G. LANGDON ; J. RISSANEN.** A Simple General Binary Source code. *IEEE Transactions on Information Theory,* 1982, vol. 28, 800-803
- **C. E. SHANNON.** A Mathematical Theory of Communication. *Bell Syst. Tech. Journal,* 1948, vol. 27, 379-423623-656
- **P. ELIAS.** Information Theory and Coding. Mc-Gra-Hill, 1963
- **J. RISSANEN.** Generalized Kraft Inequality and Arithmetic Coding. *IBM J. Res. Develop.,* 1976, vol. 20, 198-203
- **R. C. PASCO.** Source Coding and Algorithms for Fast Data Compression. *Ph. D. Dissertation, Stanford University, USA,* 1976
- **G. G. LANGDON.** An Introduction to Arithmetic Coding. *IBM J. Res. Develop.,* 1984, vol. 28, 135-149
- **A. MOFFAT ; R. M. NEAL ; I. H. WITTEN.** Arithmetic Coding Revisited. *Proc. IEEE Data Compression Conference, Snowbird (USA,* 1996, 202-211
- **J. RISSANEN ; K. M. MOHIUDDIN.** A Multiplication-Free Multialphabet Arithmetic Arithmetic Code. *IEEE Trans, on Communication,* 1989, vol. 37, 93-98
- **W. B. PENNEBAKER ; J. L. MITCHELL ; G. G. LANGDON ; R. B. ARPS.** An Overview of the Basic Principles of the Q-Coder Adaptive Binary Arithmetic Coder. *IBM J. Res. Develop.,* 1988, vol. 32, 717-726
- **P. G. HOWARD ; J. S. VITTER.** Practical Implementations of Arithmetic Coding'', in ''Image and Text Compression. Kluwer, 1992
- **L. HUYNH ; A. MOFFAT.** A Probability-Ratio Approach to Approximate Binary Arithmetic Coding. *IEEE Trans. on Information Theory,* 1997, vol. 43, 1658-1662
- **D. CHEVION ; E. D. KARNIN ; E. WALACH.** High-Efficiency, Multiplication Free Approximation of Arithmetic Coding. *Proc. IEEE Data Compression Conferenc, Snowbird (USA,* 1991, 43-52
- **G. FEYGIN ; P. G. GULAK ; P. CHOW.** Minimizing Excess Code Length and VLSI Complexity in the Multiplication Free Approximation of Arithmetic Coding. *Inform. Proc. Manag.,* 1991, vol. 30, 805-816
- **D. L. DUTTWEILER ; CH. CHAMZAS.** Probability Estimation in Arithmetic and Adaptive-Huffman Entropy Coders. *IEEE Trans. on Image Processing,* 1995, vol. 4, 237-246